(19) Europäisches Patentamt
European Patent Office
Office européen des brevets

(11) EP 4 033 556 B1

(12) EUROPEAN PATENT SPECIFICATION

(45) Date of publication and mention of the grant of the patent:
**02.07.2025 Bulletin 2025/27**

(21) Application number: **20865694.2**

(22) Date of filing: **27.08.2020**

(51) International Patent Classification (IPC):
***H10K 85/60*** *(2023.01)* *H10K 50/11* *(2023.01)*
*H10K 50/16* *(2023.01)* *H10K 101/30* *(2023.01)*
*H10K 101/40* *(2023.01)* *H10K 101/00* *(2023.01)*

(52) Cooperative Patent Classification (CPC):
**H10K 85/615; H10K 50/11; H10K 50/166; H10K 85/622; H10K 85/626; H10K 85/654; H10K 85/6572; H10K 85/6574;** H10K 2101/30; H10K 2101/40; H10K 2101/90

(86) International application number:
**PCT/KR2020/011490**

(87) International publication number:
**WO 2021/054640 (25.03.2021 Gazette 2021/12)**

(54) **ORGANIC ELECTROLUMINESCENT DEVICE**

ORGANISCHE ELEKTROLUMINESZENTE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.09.2019 KR 20190113646**

(43) Date of publication of application:
**27.07.2022 Bulletin 2022/30**

(73) Proprietor: **Solus Advanced Materials Co., Ltd.**
**Iksan-si, Jeollabuk-do 54584 (KR)**

(72) Inventors:
- **HAN, Songie**
  **Yongin-si, Gyeonggi-do 16858 (KR)**
- **PARK, Hocheol**
  **Yongin-si, Gyeonggi-do 16858 (KR)**
- **KIM, Youngmo**
  **Yongin-si, Gyeonggi-do 16858 (KR)**
- **JUNG, Seungeun**
  **Yongin-si, Gyeonggi-do 16858 (KR)**
- **KIM, Geunhyeong**
  **Yongin-si, Gyeonggi-do 16858 (KR)**
- **SONG, Hyobum**
  **Yongin-si, Gyeonggi-do 16858 (KR)**
- **KIM, Taehyung**
  **Yongin-si, Gyeonggi-do 16858 (KR)**

(74) Representative: **Office Freylinger**
**P.O. Box 48**
**8001 Strassen (LU)**

(56) References cited:
**EP-A1- 3 480 278**
**WO-A1-2019/163825**
**KR-A- 20120 029 258**
**KR-A- 20160 063 513**
**KR-A- 20180 007 243**
**KR-A- 20180 072 245**
**KR-A- 20180 072 245**
**KR-A- 20190 088 651**
**KR-A- 20190 088 651**
**KR-B1- 101 884 130**
**US-A1- 2016 149 150**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 033 556 B1

## Description

### [TECHNICAL FIELD]

The present invention relates to an organic electroluminescent device simultaneously exhibiting effects such as high luminous efficiency, low driving voltage, and a long lifespan.

### [BACKGROUND ART]

In general, in organic electroluminescent devices ("organic EL devices"), when current or voltage is applied to two electrodes, holes are injected into an organic layer at an anode, and electrons are injected into an organic layer at a cathode. When the injected holes and electrons meet, an exciton is formed, and light is emitted when the exciton falls to the ground state.

Such organic EL devices may be classified, according to an electron spin type of the formed excitons, into fluorescent EL devices in which singlet excitons contribute to light emission and phosphorescent EL devices in which triplet excitons contribute to light-emission.

Theoretically, fluorescent EL devices may have an internal quantum efficiency of up to 25%, depending on the generation ratio, whereas phosphorescent EL devices may have an internal quantum efficiency of up to 100%. In the case of phosphorescence, high internal quantum efficiency may be obtained because triplets and singlets are involved in internal quantum efficiency, but in the case of fluorescence, only singlet transition occurs, so the maximum internal quantum efficiency is about a quarter of that of phosphorescence. As such, the phosphorescent EL devices have theoretically higher luminous efficiency than the fluorescence.

However, unlike green and red phosphorescent EL devices, blue phosphorescent EL devices have not been commercialized due to a low development level of phosphorescent dopants having deep blue color purity and high efficiency and hosts having a wide energy gap. Accordingly, blue fluorescent EL devices are in use instead of the blue phosphorescent EL devices.

However, the development of organic EL devices having high efficiency and a long lifespan is required in accordance with the recent trend of display enlargement and high resolution. In particular, the high resolution of the display may be realized when more pixels are formed in the same area. For this reason, the light-emitting area of the organic EL devices may decrease, and accordingly, the decrease in the light-emitting area serves as a cause of shortening the life of the organic EL devices.

Accordingly, various studies have been conducted to improve the characteristics of the organic EL device, but satisfactory results have not been obtained so far.

EP3480278A1 relates to a display device comprising an anode; a cathode; and an organic layer disposed between the anode and the cathode and comprising a hole transport region, a light-emitting layer, and an electron transport region sequentially disposed on the anode, wherein the electron transport region comprises an electron transport auxiliary layer, an electron transport layer and an electron injection layer, the light-emitting layer comprises a plurality of hosts and dopants.

KR101884130B1 discloses an organic electroluminescent device comprising a structure in which an anode, a hole transport region, a light emitting layer, an electron transport region, and a cathode are sequentially stacked.

US2016/149150A1 discloses an organic light-emitting diode including a first electrode, a second electrode, an emitting layer, a hole transport region, a first electron transport region, an interlayer, a second electron transport region.

KR2018 0072245A discloses an organic electroluminescent device comprising a positive electrode; a negative electrode; and an organic matter layer composed of one or more layers interposed between the positive electrode and the negative electrode and including a light emitting layer and an electron transporting layer. The organic electroluminescent device further includes an electron transporting auxiliary layer between the light emitting layer and the electron transporting layer. The electron transporting auxiliary layer includes an electron transporting compound and an n-type dopant.

KR20190088651A discloses an organic electroluminescent device including multiple light emitting layers. The organic electroluminescent device has a positive electrode, a hole transport region layer, a light emitting region layer, an electron transport region layer, and a negative electrode.

### [DETAILED DESCRIPTION OF THE INVENTION]

### [TECHNICAL OBJECTIVES]

The present invention is directed to an organic electroluminescent device in which a light-emitting layer includes a plurality of hosts and dopants, where one of the plurality of hosts includes the same material as in an electron transport

auxiliary layer, whereby the organic electroluminescent device exhibits effects such as low driving voltage, high luminous efficiency, and a long lifespan.

## [TECHNICAL SOLUTION TO THE PROBLEM]

The present invention provides an organic electroluminescent device including: an anode; a cathode disposed opposing the anode; and an organic layer disposed between the anode and the cathode and comprising a hole transport region, a light-emitting layer, and an electron transport region sequentially disposed on the anode, wherein the electron transport region comprises an electron transport auxiliary layer, an electron transport layer and an electron injection layer sequentially disposed on the light-emitting layer, the light-emitting layer comprises a plurality of hosts and dopants, and one of the plurality of hosts comprises a material the same as a material of the electron transport auxiliary layer.

## [EFFECTS OF THE INVENTION]

The present invention provides an organic electroluminescent device in which a light-emitting layer includes a plurality of hosts and dopants, where one of the plurality of hosts includes the same material as in an electron transport auxiliary layer, whereby the organic electroluminescent device exhibits effects such as low driving voltage, high luminous efficiency, and a long lifespan.
The present invention further provides a display panel with improved performance and lifespan by applying the organic electroluminescent device of the present invention to the display panel.

## [BRIEF DESCRIPTION OF DRAWINGS]

FIG. 1 is a cross-sectional view illustrating a structure of an organic electroluminescent ("EL") device according to an embodiment of the present invention.
FIG. 2 is a cross-sectional view illustrating a structure of an organic EL device according to another embodiment of the present invention.
FIG. 3 is a graph illustrating relationship of a highest occupied molecular orbital ("HOMO") energy level between a light-emitting layer and an electron transport auxiliary layer according to an embodiment of the present invention.
FIG. 4 is a graph illustrating relationship of a lowest unoccupied molecular orbital ("LUMO") energy level between a light-emitting layer, an electron transport auxiliary layer, and an electron transport layer according to an embodiment of the present invention.

** Referential numeral **

100: anode, 200: cathode,
300: organic layer, 310: hole transport region,
311: hole injection layer, 312: hole transport layer,
313: hole transport auxiliary layer, 320: light-emitting layer,
330: electron transport region, 331: electron transport auxiliary layer;
332: electron transport layer, 333: electron injection layer

## [MODES FOR CARRYING OUT THE INVENTION]

Advantages and features of the present invention and methods for achieving them will become apparent with reference to embodiments described below in detail in conjunction with the accompanying drawings. However, the present invention is not limited to the embodiments disclosed below but may be implemented in various different forms, and it is to be understood that the present embodiments are merely provided to make the disclosure of the present invention complete and to fully convey the scope of the present invention to those of ordinary skill in the art, and the present invention is defined only by the scope of the claims. Thus, in some embodiments, well-known process steps, well-known device structures and well-known techniques are not described in detail in order to avoid obscuring the present invention. Like reference numerals refer to like elements throughout the specification.
Unless otherwise defined, all terms used in the present specification (including technical and scientific terms) may be used with meanings that may be commonly understood by those skilled in the art. In addition, the terms defined in

the commonly used dictionaries are not ideally or excessively interpreted, unless they are specifically defined clearly.

An organic electroluminescent ("EL") device according to the present invention includes: an anode; a cathode disposed opposing the anode; and one or more organic layers disposed between the anode and the cathode and including a hole transport region, a light-emitting layer, and an electron transport region, where the same material as in an electron transport auxiliary layer in the electron transport region is used in one of a plurality of hosts in the light-emitting layer, wherein a material for the electron transport auxiliary layer is defined in claim 1.

Accordingly, the organic EL device of the present invention may have characteristics such as a low driving voltage, a high luminous efficiency and a long lifespan.

Specifically, in the organic EL device of the present invention, the light-emitting layer includes a plurality of hosts, for example, a first host and a second host different from each other, to prevent reverse transfer phenomenon in which exciton transferred from the host to the dopant is transferred back to the host, while improving recombination efficiency of the holes and electrons.

In such a case, an electron transport auxiliary layer may be disposed between the light-emitting layer and the electron transport layer, and one of the plurality of hosts may include a material the same as a material of the electron transport auxiliary layer, such that an electron injection barrier between the light-emitting layer and the electron transport layer may be lowered, and barrier-free effects between the light-emitting layer and the electron transport auxiliary layer may be exhibited, thereby allowing electrons injected from the electron transport layer to be smoothly supplied to the light-emitting layer through the electron transport auxiliary layer. Accordingly, in the organic EL device of the present invention, luminous efficiency may be enhanced, a driving voltage may be lowered, and lifespan characteristics may be significantly improved.

Hereinafter, embodiments of the organic EL device according to the present invention will be described with reference to the accompanying drawings. However, embodiment of the present invention may be modified into various other forms, and the scope of the present invention is not limited to the embodiments described below.

FIG. 1 is a cross-sectional view illustrating a structure of an organic electroluminescent ("EL") device according to an embodiment of the present invention. FIG. 2 is a cross-sectional view illustrating a structure of an organic EL device according to another embodiment of the present invention.

Referring to FIGS. 1 and 2, the organic EL device sequentially includes an anode 100, one or more organic layers 300, and a cathode 200, and the organic layer 300 includes a hole transport region 310, a light-emitting layer 320, and an electron transport region 330. Optionally, the organic EL device may further include a capping layer (not illustrated) disposed on the cathode 200.

Hereinafter, each structure of the organic EL device according to the present invention will be described in detail.

(1) Anode

The organic EL device of the present invention includes the anode 100. The anode 100 may be disposed on a substrate and electrically connected to a driving thin film transistor ("TFT") to receive a driving current from the driving thin film transistor. Since the anode 100 includes or is formed of a material having a relatively high work function, it may inject holes into an adjacent one of the organic layers, that is, the hole transport region 310 (e.g., a hole injection layer 311).

A material for forming the anode is not particularly limited, and a conventional one known in the art may be used. Examples thereof may include metals, such as vanadium, chromium, copper, zinc, and gold; alloys thereof; metal oxides such as zinc oxide, indium oxide, indium tin oxide (ITO), and indium zinc oxide (IZO); combinations of metals and oxides such as ZnO:Al and $SnO_2$:Sb; conductive polymers such as polythiophene, poly(3-methylthiophene), poly[3,4-(ethylene-1,2-dioxy)thiophene] (PEDT), polypyrrole, and polyaniline; and carbon black, but embodiments are not limited thereto.

A method of preparing the anode is not particularly limited, and may be prepared through a conventional method known in the art. For example, the anode may be formed by coating the anode material on a substrate through a known thin film forming method such as a sputtering method, an ion plating method, a vacuum deposition method, or a spin coating method.

The substrate may be a plate-shaped member for supporting the organic EL device, and include, for example, a silicon wafer, quartz, a glass plate, a metal plate, a plastic film, and a sheet, but embodiments are not limited thereto.

(2) Cathode

In the organic EL device of the present invention, the cathode 200 is disposed opposing the anode, and specifically, disposed on the electron transport region 330. Since the cathode 200 includes or is formed of a material having a relatively low work function, it may inject electrons into an adjacent one of the organic layers, that is, the electron transport region 330 (e.g., an electron injection layer 333).

A material for forming the cathode is not particularly limited, and a conventional one known in the art may be used.

Examples thereof may include metals, such as magnesium, calcium, sodium, potassium, titanium, indium, yttrium, lithium, gadolinium, aluminum, silver (Ag), tin, and lead; alloys thereof; and a multi-layer structure material such as LiF/Al or $LiO_2$/Al, but embodiments are not limited thereto.

A method of preparing the cathode is not particularly limited, and similar to the anode, the cathode may be prepared through a conventional method known in the art. For example, the cathode may be formed by coating the cathode material on the one or more organic layers 300, specifically on the electron transport region, for example, the electron injection layer 333, through the above-described thin film forming method.

(3) Organic layer

In the organic EL device of the present invention, the one or more organic layers 300 are disposed between the anode 100 and the cathode 200.

The organic layer 300 includes the hole transport region 310, the light-emitting layer 320, and the electron transport region 330.

According to an embodiment, as illustrated in FIG. 1, the one or more organic layers 300 may include a hole injection layer 311, a hole transport layer 312, a hole transport auxiliary layer 313, a light-emitting layer 320, an electron transport auxiliary layer 331, an electron transport layer 332, and an electron injection layer 333 sequentially disposed on the anode 100.

According to another embodiment, as illustrated in FIG. 2, the one or more organic layers 300 may include a hole injection layer 311, a hole transport layer 312, a hole transport auxiliary layer 313, a light-emitting layer 320, an electron transport auxiliary layer 331, an electron transport layer 332, and an electron injection layer 333 sequentially disposed on the anode 100.

Hereinafter, each organic layer will be described.

1) Hole transport region

In the organic EL device 100 of the present invention, the hole transport region 310 is a portion of the organic layer 300 disposed on the anode 100, and serves to allow holes injected from the anode 100 to migrate into another adjacent one of the organic layers, specifically to the light-emitting layer 320. The hole transport region 310 may include at least one of the hole injection layer 311, the hole transport layer 312, and the hole transport auxiliary layer 313.

For example, as illustrated in FIG. 1, the hole transport region 310 may include the hole injection layer 311 and the hole transport layer 312 sequentially stacked on the anode 100.

As another example, as illustrated in FIG. 2, the hole transport region 310 may include the hole injection layer 311, the hole transport layer 312, and the hole transport auxiliary layer 313 sequentially stacked on the anode 100.

A material forming the hole injection layer 311 and the hole transport layer 312 of the present invention is not particularly limited as long as it has a low hole injection barrier and a high hole mobility, and any material for the hole injection/transport layer may be used without limitation. In such a case, respective materials for forming the hole injection layer 311 and the hole transport layer 312 may be the same or different from each other.

Specifically, the hole injection layer 311 may include a hole injection material known in the art. Non-limiting examples of the hole injection material may include phthalocyanine compounds such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-tris(3-methylphenylphenylamino) triphenylamine), TDATA (4,4'4"-Tris(N,N-diphenylamino)triphenylamine), 2TNATA (4,4',4"-tris {N,-(2-naphthyl)-N-phenylamino}-triphenylamine), PEDOT/PSS (poly(3,4-ethylenedioxythiophene)/poly(4-styrenesulfonate)), PANI/DBSA (polyaniline/dodecylbenzenesulfonic acid), PANI/CSA (polyaniline/Camphor sulfonicacid), PANI/PSS ((polyaniline)/poly(4-styrenesulfonate)), and the like, which may be used solely or in combination of two or more thereof.

The hole transport layer 312 includes a hole transport material known in the art. Non-limiting examples of the hole transport material may include carbazole-based derivatives such as N-phenylcarbazole and polyvinylcarbazole; fluorene-based derivatives, amine-based derivatives; triphenylamine-based derivatives such as TPD (N,N'-bis(3-methylphenyl)-N,N'-diphenyl-[1,1-biphenyl]-4,4'-diamine) and TCTA (4,4',4"-tris(N-carbazolyl)triphenylamine); NPB (N,N'-di(1-naphthyl)-N,N'-diphenylbenzidine), TAPC (4,4'-cyclohexylidene bis[N,N-bis(4-methylphenyl)benzenamine]), and the like, which may be used solely or in combination of two or more thereof.

The hole transport auxiliary layer 313 may prevent electrons or excitons generated in the light-emitting layer 320 from diffusing (migrating) into the hole transport region 310. A material of the hole transport auxiliary layer 313 may be used without limitation as long as it has general hole transport properties known in the art, and may be, for example, the above-described hole transport material.

The hole transport region 310 may be formed through a conventional method known in the art. For example, there may be a vacuum deposition method, a spin coating method, a casting method, a Langmuir-Blodgett (LB) method, an

inkjet printing method, a laser printing method, a laser induced thermal imaging (LITI) method, and the like, but embodiments are not limited thereto.

2) Light-emitting layer

In the organic EL device of the present invention, the light-emitting layer 320 is a portion of the organic layer 300 disposed between the anode 100 and the cathode 200, and specifically disposed on the hole transport region 320. Specifically, the light-emitting layer 320 may be disposed on the hole transport layer 312 or on the hole transport auxiliary layer 313 (see FIGS. 1 and 2). The light-emitting layer 320 is a layer in which holes and electrons injected from the anode and the cathode, respectively, are combined to form excitons, and a color of light emitted by the organic EL device may vary depending on the material forming the light-emitting layer 320.

The light-emitting layer 320 of the present invention includes a plurality of hosts and dopants. In such a case, one of the plurality of hosts is (e.g., is or includes) a material the same as (e.g., identical to) a material included in or forming the electron transport auxiliary layer ("electron transport auxiliary layer material").

According to an embodiment, the plurality of hosts may include: a first host that is the same as the electron transport auxiliary layer material; and a second host different from the first host. As such, when one of the plurality of hosts is the same as the electron transport auxiliary layer material, barrier-free effects may be exhibited between the light-emitting layer and the electron transport auxiliary layer, thereby realizing a low driving voltage, a high luminous efficiency and a long lifespan of the device.

The first host of the present invention is a material the same as a material of the electron transport auxiliary layer. Specifically, the first host may be a compound including at least one of moieties represented by the following Chemical Formulas A-1 to A-16. For example, the first host may be a compound represented by any one of the following Chemical Formulas B-1 to B-9.

According to an embodiment the first host (not according to the invention) may be one of the following compounds 1, 4, 5, 7, 12; while the first host (according to the invention) may be one of the following compounds 2, 3, 6, 8, 9, 10, 11, 13 and 14.

A detailed description of these compounds will be described below in a section of the electron transport auxiliary layer.

The second host of the present invention is a host different from the first host, any host known in the art may be used without particular limitation, and non-limiting examples thereof may include alkali metal complex compounds; alkaline earth metal complex compounds; or aromatic ring-fused derivatives. Specifically, examples of the second host may include aluminum complex compounds, beryllium complex compounds, iridium compounds, anthracene derivatives, pyrene derivatives, triphenylene derivatives, carbazole derivatives, dibenzofuran derivatives, dibenzothiophene derivatives, fluorene derivatives, nitrogen-containing heterocyclic derivatives, or a combination of one or more thereof which may enhance luminous efficiency and lifespan of the organic EL device.

However, in the present invention, in order to prevent reverse transfer phenomenon of excitons, while significantly increasing the number of excitons in the light-emitting layer, in selecting the second host, differences in physical properties such as a HOMO energy level difference or a LUMO energy level difference with respect to the first host needs to be considered.

According to an embodiment, the second host may be a material satisfying the following Relational Expressions 1 and 2:

[Relational Expression 1]

$$|LUMO_{host-1}| > |LUMO_{host-2}|$$

[Relational Expression 2]

$$|HOMO_{host-1}| > |HOMO_{host-2}|$$

in the above Relational Expressions,

$LUMO_{host-1}$ is a LUMO energy level of the first host,
$LUMO_{host-2}$ is a LUMO energy level of the second host,
$HOMO_{host-1}$ is a HOMO energy level of the first host, and

$HOMO_{host-2}$ is a HOMO energy level of the second host.

Specifically, a difference between an absolute value of the LUMO energy level of the second host and an absolute value of the LUMO energy level of the first host may be in a range of greater than 0 eV to 1.0 eV or less, and a difference between an absolute value of the HOMO energy level of the second host and an absolute value of the HOMO energy level of the first host may be in a range of greater than 0 eV to 1.0 eV or less.

A content of hosts (e.g., the first host) that are the same as the electron transport auxiliary layer material from among the plurality of hosts may be in a range of 30 to 90 percent by weight (wt%) with respect to the total amount of entire hosts. For example, when the plurality of hosts include the first host which is the same as the electron transport auxiliary layer material and the second host different from the first host, a use ratio of the first host and the second host is not particularly limited, and for example, the ratio may be in a range of 30:70 to 90:10 by weight. If the use ratio of the first host and the second host is within the above ratio, the dopant-to-host exciton reverse transfer phenomenon may be more effectively prevented, while achieving increased barrier-free effects between the light-emitting layer and the electron transport auxiliary layer.

Optionally, the light-emitting layer of the present invention may further include one or more other hosts (e.g., a third host) different from the first and second hosts described above. In such a case, an example of the third host may be the same as the examples of the second host, and thus description thereof will be omitted.

In the light-emitting layer of the present invention, any dopant commonly known in the art may be used as the dopant without particular limitation. Such dopants may be classified into fluorescent dopants and phosphorescent dopants, and the phosphorescent dopant may be an organometallic complex including Ir, Pt, Os, Re, Ti, Zr, Hf, or a combination of two or more thereof, but embodiments are not limited thereto.

In an embodiment, the dopant may be classified into red dopants, green dopants, and blue dopants, and red dopants, green dopants, and blue dopants commonly known in the art may be used without particular limitation.

Specifically, non-limiting examples of the red dopant may include PtOEP (Pt(II) octaethylporphine), $Ir(piq)_3$ (tris(2-phenylisoquinoline)iridium), $Btp_2Ir(acac)$ (bis(2-(2'-benzothienyl)-pyridinato-N,C3')iridium(acetylacetonate), and the like, which may be used solely or in combination of two or more thereof.

In addition, non-limiting examples of the green dopant may include $Ir(ppy)_3$ (tris(2-phenylpyridine) iridium), $Ir(ppy)_2(acac)$ (bis(2-phenylpyridine)(Acetylacetonato)iridium(III)), $Ir(mppy)_3$ (tris(2-(4-tolyl)phenylpiridine)iridium), C545T (10-(2-benzothiazolyl)-1,1,7,7-tetramethyl-2,3,6,7-tetrahydro-1H,5H,11H-[1]benzopyrano [6,7,8-ij]-quinolizin-11-one, and the like, which may be used solely or in combination of two or more thereof.

In addition, non-limiting examples of the blue dopant may include $F_2Irpic$ (bis[3,5-difluoro-2-(2-pyridyl)phenyl] (picolinato)iridium(III)), $(F_2ppy)_2Ir(tmd)$, $Ir(dfppz)_3$, DPVBi (4,4'-bis(2,2'-diphenylethen-1-yl)biphenyl), DPAVBi (4,4'-Bis [4-(diphenylamino)styryl]biphenyl), TBPe (2,5,8,11-tetra-tert-butyl perylene), and the like, which may be used solely or in combination of two or more thereof.

Contents of the dopants are not particularly limited and may be appropriately adjusted within a range known in the art.

For example, the plurality of hosts and the plurality of dopants may be included with a weight ratio in a range of 70:30 to 99.9:0.1 with respect to the total amount of the light-emitting layer. Specifically, when the light-emitting layer 320 is blue fluorescent, green fluorescent, or red fluorescent, the plurality of hosts and the plurality of dopants may be included with a weight ratio in a range of 80:20 to 99.9:0.1. In addition, when the light-emitting layer 320 is blue fluorescent, green fluorescent, or red phosphorescent, the plurality of hosts and the plurality of dopants may be included with a weight ratio in a range of 70:30 to 99:1.

In another example, the content of the dopant may be in a range of about 0 to 30 parts by weight, specifically more than 0 parts by weight to 20 pats by weight or less, more specifically in a range of about 0.1 to 15 parts by weight, with respect to 100 parts by weight of the total amount of the first hosts and the second hosts.

The above-described light-emitting layer 320 may be a single layer or may be formed of a plurality of layers of two or more layers. In such a case, when the light-emitting layer 320 includes a plurality of layers, the organic EL device may emit light of various colors. Specifically, the present invention may provide an organic EL device having a mixed color by providing, in series, a plurality of light-emitting layers including or formed of heterogeneous materials. In addition, when including the plurality of light-emitting layers, a driving voltage of the device may increase, while a current value in the organic EL device becomes constant, and accordingly, it is possible to provide an organic EL device with improved luminous efficiency by the number of light-emitting layers.

The light-emitting layer 320 may be formed through a conventional method known in the art. For example, there may be a vacuum deposition method, a spin coating method, a casting method, a Langmuir-Blodgett (LB) method, an inkjet printing method, a laser printing method, a laser induced thermal imaging (LITI) method, and the like, but embodiments are not limited thereto. For example, the light-emitting layer may be formed by co-deposition of the plurality of hosts (e.g., a first host and a second host) mixed with each other.

3) Electron transport region

In the organic EL device according to the present invention, the electron transport region 330 is an organic layer disposed on the light-emitting layer 320, and allows electrons injected from the cathode 200 to migrate to the light-emitting layer 320.

The electron transport region 330 includes the electron transport auxiliary layer 331, the electron transport layer 332, and the electron injection layer 333 sequentially disposed on the light-emitting layer 320.

The electron transport auxiliary layer 331 according to the present invention facilitates migration of electrons from the electron transport layer 332 to the light-emitting layer 320, and prevents excitons generated in the light-emitting layer 320 or holes injected into the light-emitting layer 320 from being diffused (e.g., migrating) to the electron transport layer 332. A material for forming the electron transport auxiliary layer 331 is also not particularly limited as long as it has a low electron injection barrier and high electron mobility, and any material known in the art may be used without particular limitation.

However, in the present invention, in order to achieve barrier-free effects between the light-emitting layer and the electron transport auxiliary layer, a material of the electron transport auxiliary layer may be the same as one of the plurality of hosts (e.g., the first host) in the light-emitting layer. In particular, the electron transport auxiliary layer may be formed by using a host having a low electron injection barrier and a high electron mobility from among the plurality of hosts in the light-emitting layer. Accordingly, in the organic EL device of the present invention, electrons injected from the electron transport layer may be smoothly supplied to the light-emitting layer through the electron transport auxiliary layer, such that a combination rate between holes and electrons may be increased, and thus the number of excitons may be significantly increased. Accordingly, the organic EL device of the present invention may exhibit high-efficiency luminous characteristics, and furthermore, as the driving voltage is lowered, life-span characteristics may be significantly improved.

In such a case, in order to achieve the barrier-free effects between the electron transport auxiliary layer 331 and the light-emitting layer 320 as well as to lower the electron injection barrier between the electron transport auxiliary layer 331 and the electron transport layer 332, a material of the electron transport auxiliary layer 331 needs to be selected in consideration of physical properties such as a difference in HOMO energy level or a difference in LUMO energy level between the electron transport auxiliary layer 331, the electron transport layer 332, and the light-emitting layer 320.

According to an embodiment, the material of the electron transport auxiliary layer may be selected so that the electron transport auxiliary layer 331 of the present invention satisfies the following Relational Expression 3 (see FIG. 3):

[Relational Expression 3]

$$|HOMO_{aETL}| > |HOMO_{EL}|$$

(in the above formula,

$HOMO_{aETL}$ is a HOMO energy level of the electron transport auxiliary layer, and
$HOMO_{EL}$ is a HOMO energy level of the light-emitting layer).

Specifically, a difference between an absolute value of the HOMO energy level of the electron transport auxiliary layer 331 and an absolute value of the HOMO energy level of the light-emitting layer 320 may be in a range of greater than 0 eV to 1.0 eV or less.

As such, when the absolute value of the HOMO energy level of the electron transport auxiliary layer 331 is greater than the absolute value of the HOMO energy level of the light-emitting layer 320, holes in the light-emitting layer may be blocked by the energy barrier of the electron transport auxiliary layer and migration to the electron transport auxiliary layer may be prevented, and thus combination of electrons and holes in the light-emitting layer may be increased.

According to another embodiment, the material of the electron transport auxiliary layer may be selected so that the electron transport auxiliary layer 331 of the present invention satisfies the following Relational Expression 4 (see FIG. 4):

[Relational Expression 4]

$$|LUMO_{ETL}| > |LUMO_{aETL}| > |LUMO_{EL}|$$

(in the above formula,

$LUMO_{ETL}$ is a LUMO energy level of the electron transport layer,
$LUMO_{aETL}$ is a LUMO energy level of the electron transport auxiliary layer, and
$LUMO_{EL}$ is a LUMO energy level of the light-emitting layer).

Specifically, a difference between an absolute value of the LUMO energy level of the electron transport auxiliary layer 331 and an absolute value of the LUMO energy level of the electron transport layer 332 may be in a range of greater than 0 eV to 1.0 eV or less. In addition, a difference between an absolute value of the LUMO energy level of the electron transport auxiliary layer 331 and an absolute value of the LUMO energy level of the light-emitting layer 320 may be in a range of greater than 0 eV to 1.0 eV or less.

As such, when the absolute value of the LUMO energy level of the electron transport auxiliary layer 331 is between the absolute value of the LUMO energy level of the electron transport layer 332 and the absolute value of the LUMO energy level of the light-emitting layer 320, the LUMO energy level may have a step arrangement, and electrons injected from the cathode may be smoothly injected from the electron transport layer to the light-emitting layer.

Any material having physical properties such as the above-described HOMO energy level and LUMO energy level may be used as the electron transport auxiliary layer material of the present invention.

For example, the material of the electron transport auxiliary layer 331 (not according to the present invention) may be a compound including one or more of moieties represented by the following Chemical Formulas 1 and 2 ("one or more moiety-containing compounds"):

[Chemical Formula 1]

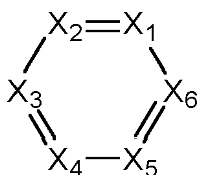

[Chemical Formula 2]

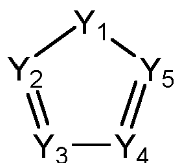

where in Chemical Formulas 1 and 2,

$X_1$ to $X_6$ may be the same as or different from each other, each independently being N or $C(R_1)$, where at least one of $X_1$ to $X_6$ (specifically, one to three of $X_1$ to $X_6$) may be N, and when $C(R_1)$ is plural in number, the plurality of $R_1$ may be the same as or different from each other,

$Y_1$ to $Y_5$ may be the same as or different from each other, each independently being N or $C(R_2)$, where at least one of $Y_1$ to $Y_5$ (specifically, one to three of $Y_1$ to $Y_5$) may be N, and when $C(R_2)$ is plural in number, the plurality of $R_2$ may be the same as or different from each other,

$R_1$ and $R_2$ may be the same as or different from each other, each independently being selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or forming a fused ring (e.g., a condensed ring) with an adjacent group, and

the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the phosphine group, and the phosphine oxide group of $R_1$ and $R_2$ may each be independently substituted or unsubstituted with one or more substituents of: hydrogen, deuterium (D), a halogen group, a cyano group, a nitro group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$

arylphosphine group, a $C_6$ to $C_{60}$ arylphosphine oxide group and a $C_6$ to $C_{60}$ arylamine group, and when the substituents are plural in number, the substituents may be the same as or different from each other.

In Chemical Formula 1, when $R_1$ combines with an adjacent group to form a fused ring, the moiety represented by Chemical Formula 1 may be a moiety represented by Chemical Formula 3, but embodiments are not limited thereto:

[Chemical Formula 3]

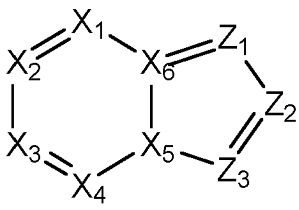

where in Chemical Formula 3,

$X_1$ to $X_6$ may be the same as those defined in Chemical Formula 1 above, respectively,

$Z_1$ to $Z_3$ may be the same as or different from each other, each independently being N or $C(R_3)$, where at least one of $Z_1$ to $Z_3$ (specifically, one or two of $Z_1$ to $Z_3$) is N, and when $C(R_3)$ is plural in number, the plurality of $R_3$ are the same as or different from each other,

$R_3$ may be selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or may form a fused ring with an adjacent group, and

the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the phosphine group, and the phosphine oxide group of $R_3$ may be substituted or unsubstituted with one or more substituents of: hydrogen, deuterium, a halogen group, a cyano group, a nitro group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, and when the substituents are plural in number, the substituents may be the same as or different from each other.

The at least one moiety-containing compound described above has an electron withdrawing group ("EWG") property in which the moieties of Chemical Formulas 1 and 2 have high electron absorbable properties. Accordingly, when the at least one moiety-containing compound is applied as materials of both of the electron transport auxiliary layer and one of the plurality of hosts of the light-emitting layer, electrons injected from the cathode may be smoothly supplied from the electron transport layer to the light-emitting layer, and accordingly, the driving voltage of the organic EL device may be lowered, and high efficiency and long lifespan may be induced.

In addition, the at least one moiety-containing compound has a high glass transition temperature because a molecular weight of the compound may be significantly increased by controlling various types and introduction positions of the substituents that are introduced into the moieties of Chemical Formulas 1 and 2, and thus thermal stability of the organic EL device may be improved, and there may also be an effect of inhibiting crystallization of the organic layer, and thus durability and lifespan characteristics of the device may be greatly improved.

Specifically, the at least one moiety-containing compound may be a compound represented by any one of the following Chemical Formulas 4 to 6 (not according to the present invention ):

[Chemical Formula 4]

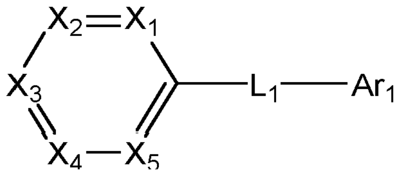

[Chemical Formula 5]

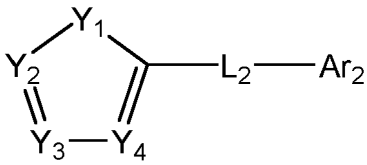

[Chemical Formula 6]

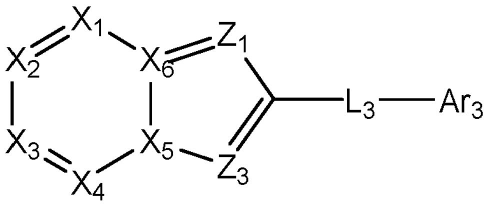

where in Chemical Formulas 4 to 6,
$X_1$ to $X_6$, $Y_1$ to $Y_4$, and $Z_1$ and $Z_3$ may be the same as those defined in Chemical Formulas 1 to 3, respectively,
$L_1$ to $L_3$ may be the same or different from each other, each independently being a single bond, or being selected from a $C_6$ to $C_{18}$ arylene group and a heteroarylene group having 5 to 18 nuclear atoms, specifically selected from: a single bond, a phenylene group, a biphenylene group, a terphenylene group, a divalent naphthyl group, a divalent phenanthryl group, a divalent anthracene group, a divalent pyrene group, a divalent chrysene group, a divalent carbazole group, a divalent dibenzofuran group, a divalent dibenzothiophene group, a divalent fluorene group, a divalent fluorancene group, a divalent triphenylene group, a divalent furan group, a divalent indole group, a divalent indene group, a divalent thiophene group, a divalent benzofuran group, a divalent benzothiophene group, a divalent benzoindene group, and combinations of two or more thereof, and
$Ar_1$ to $Ar_3$ may be the same as or different from each other, each independently being a substituent selected from the following Chemical Formulas S1 to S9:

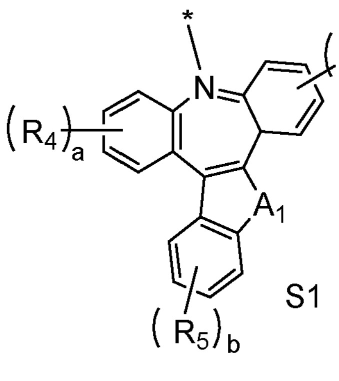

S1

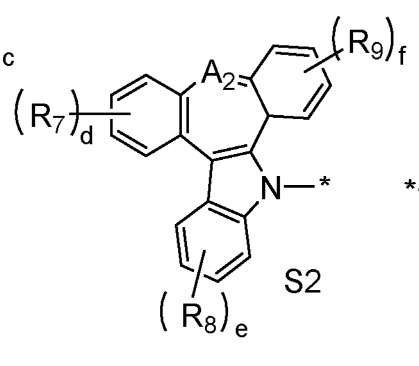

S2

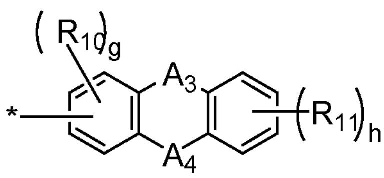

S3

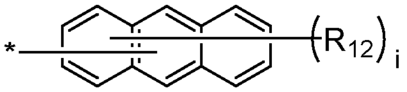
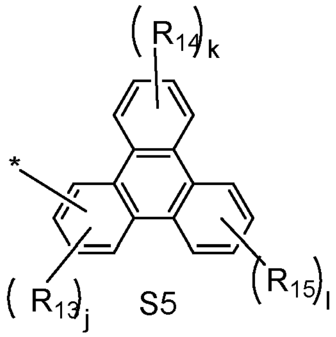
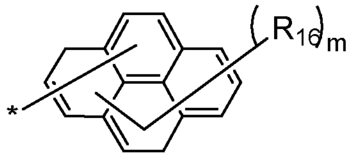

S4 S5 S6

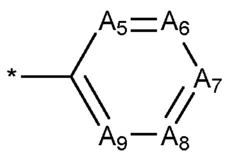
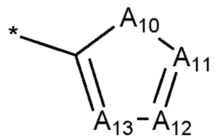
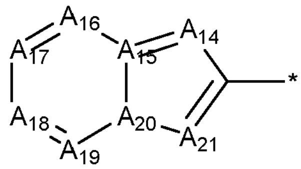

S7 S8 S9

in Chemical Formulas S1 to S9,

$A_1$ and $A_2$ may be N or $CR_{17}$,

$A_3$ and $A_4$ may be the same as or different from each other, each independently being a single bond, or being selected from: $NR_{18}$, O, S, and $CR_{19}R_{20}$, wherein a case where both of $A_3$ and $A_4$ are single bonds is excluded,

$A_5$ to $A_9$ may be N or $CR_{21}$, where at least one of $A_5$ to $A_9$ (specifically, one to three of $A_5$ to $A_9$) is N, and when $CR_{21}$ is plural in number, the plurality of $R_{21}$ are the same as or different from each other,

$A_{10}$ to $A_{13}$ may be N or $CR_{22}$, where at least one of $A_{10}$ to $A_{13}$ (specifically, one to three of $A_{10}$ to $A_{13}$) is N, and when $CR_{22}$ is plural in number, the plurality of $R_{22}$ are the same as or different from each other,

$A_{14}$ to $A_{21}$ may be N or $CR_{23}$, where at least one of $A_{14}$ to $A_{21}$ (specifically, one to four of $A_{14}$ to $A_{21}$) is N, and when $CR_{23}$ is plural in number, the plurality of $R_{23}$ are the same as or different from each other,

a, b, c, d, e, f, h, k, and l may each be an integer in a range of 0 to 4;

g and j may each be an integer in a range of 0 to 3,

i and m may each be an integer in a range of 0 to 9,

$R_4$ to $R_{23}$ may be the same as or different from each other, each independently being selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or forming a fused ring with an adjacent group, and

the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the phosphine group, and the phosphine oxide group of $R_4$ to $R_{23}$ may each independently be substituted or unsubstituted with one or more substituents of: hydrogen, deuterium, a halogen group, a cyano group, a nitro group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, and when the substituents are plural in number, the substituents may be the same as or different from each other.

Specifically, the compound represented by any one of the above Chemical Formulas 4 to 6 may be one of compounds represented by the following Chemical Formulas A-1 to A- 16, (according to the present invention) but embodiments are not limited thereto:

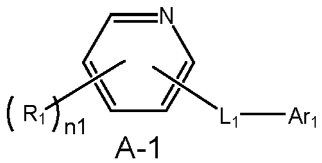
A-1

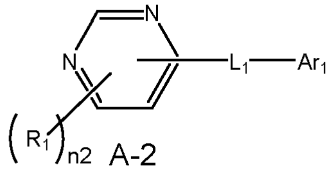
A-2

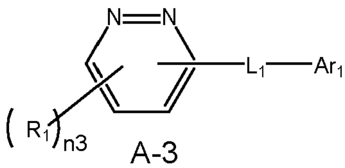
A-3

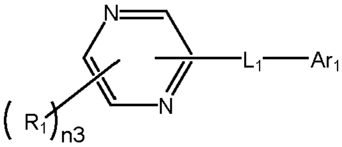
A-4

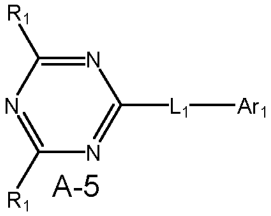
A-5

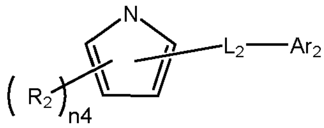
A-6

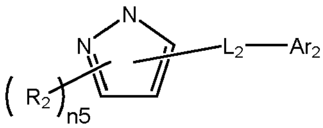
A-7

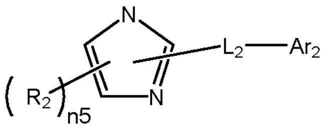
A-8

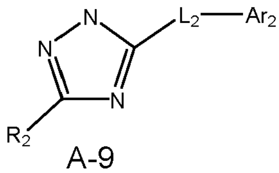
A-9

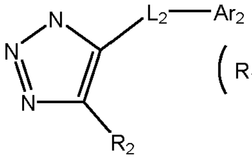
A-10

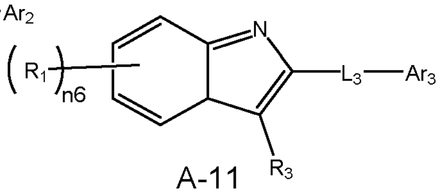
A-11

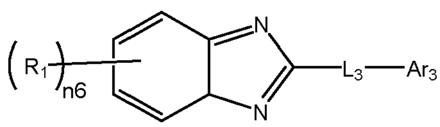
A-12

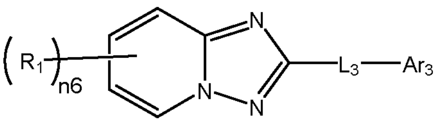
A-13

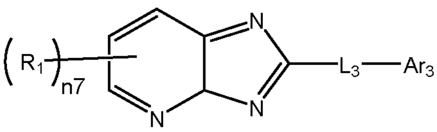
A-14

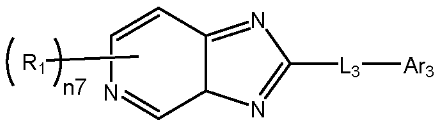
A-15

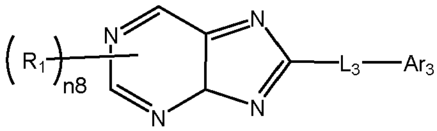
A-16

where in Chemical Formulas A-1 to A-16,

$R_1$ and $R_2$ may be the same as those defined in Chemical Formulas 1 to 3, respectively,

$L_1$ to $L_3$ and $Ar_1$ to $Ar_3$ may be the same as those defined in Chemical Formulas 4 to 6, respectively,

$n_1$ and $n_6$ may each be an integer in a range of 0 to 4,

$n_2$, $n_3$, $n_4$, and $n_7$ may each be an integer in a range of 0 to 3, and

$n_5$ and $n_8$ may each be an integer in a range of 0 to2.

More specifically, the compound represented by any one of Chemical Formulas 4 to 6 may selected from compounds represented by the following Chemical Formulas B-1 to B-9, but embodiments are not limited thereto:

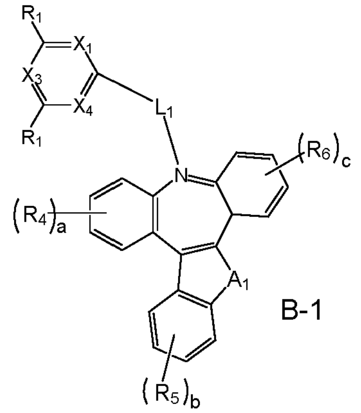
B-1

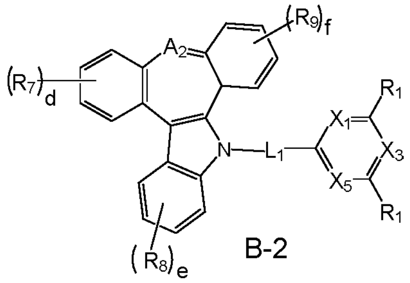
B-2

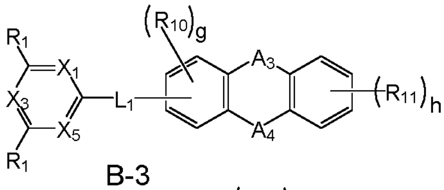
B-3

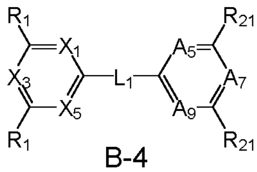
B-4

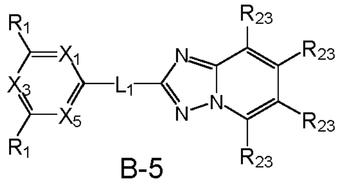
B-5

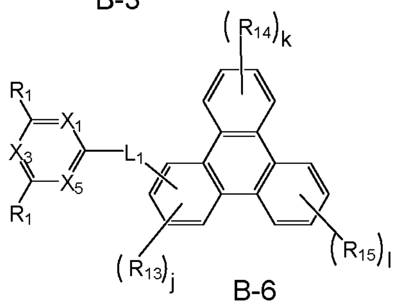
B-6

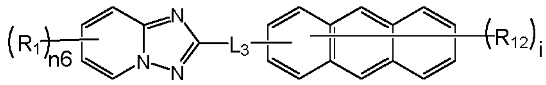
B-7

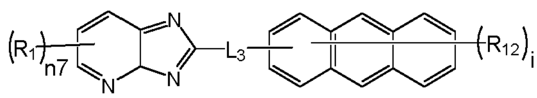
B-8

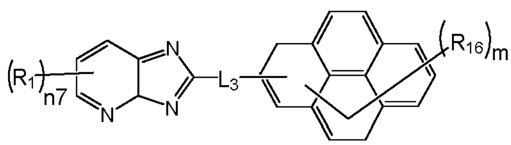
B-9

where in the above Chemical Formulas B-1 to B-9,
$X_1$, $X_3$, $X_5$, and $R_1$ may be the same as those defined in Chemical Formulas 1 to 3, respectively,
$L_1$ and $L_3$ may be the same as those defined in Chemical Formulas 4 to 6, respectively,
$A_1$ to $A_5$, $A_7$, $A_9$, $R_4$ to $R_{16}$, $R_{21}$, $R_{23}$, a to h may be the same as those defined in Chemical Formulas S1 to S9, respectively, and
$n_6$ and $n_7$ may be the same as those defined in Chemical Formulas A-1 to A-16, respectively.

The compound containing one or more moieties described above may be embodied as, but not limited to, compounds 1, 4, 5, 7, 12 not according to the present invention, while compounds 2, 3, 6, 8, 9, 10, 11, 13 and 14 according to the present invention shown below.

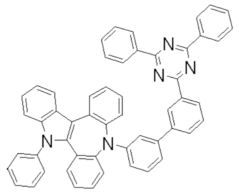
1

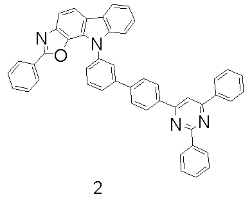
2

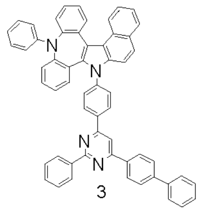
3

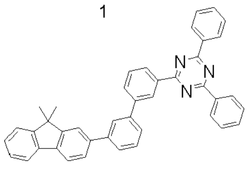
4

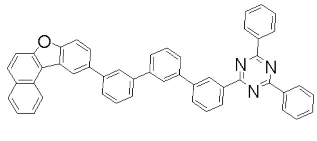
5

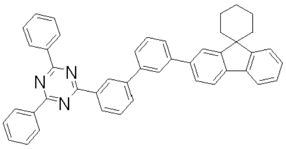
6

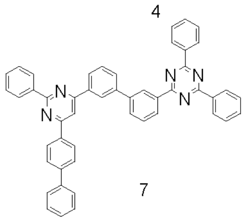
7

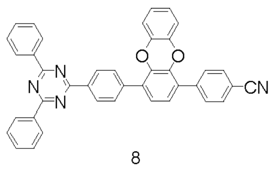
8

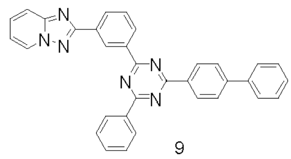
9

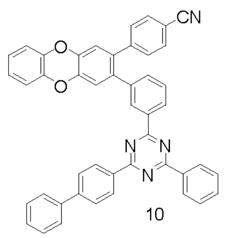
10

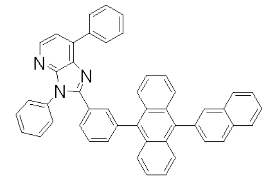
11

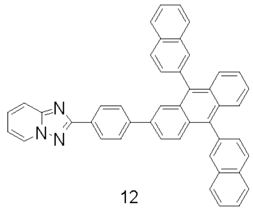
12

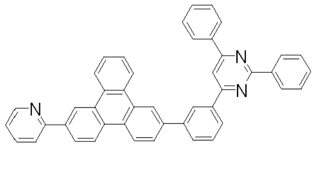
13

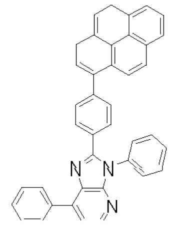
14

In the electron transport region 330 according to the present invention, any electron transport material that facilitates electron injection and has high electron mobility may be used as the electron transport layer 332 without limitation. Non-limiting examples of the electron transport material may include an oxazole-based compound, an isoxazole-based compound, a triazole-based compound, an isothiazole-based compound, an oxadiazole-based compound, a thiadiazole-based compound, a perylene-based compound, an aluminum complex [e.g., $Alq_3$ (tris(8-quinolinolato)-aluminium), BAlq, SAlq, $Alph_3$, $Almq_3$], a gallium complex (e.g., Gaq'2OPiv, Gaq'2OAc, 2(Gaq'2)) and the like, which may be used solely or in combination of two or more thereof.

In addition, as the electron injection layer 333, any electron injection material that facilitates electron injection and has high electron mobility may be used without limitation. Non-limiting examples of the electron injection material may include LiF, $Li_2O$, BaO, NaCl, and CsF; lanthanide metals such as Yb; a metal halide such as RbCl or RbI, and the like, which may be used solely or in combination of two or more thereof.

The electron transport region 330 according to the present invention, specifically, the electron transport layer 332 and/or the electron injection layer 333 may be codeposited with an n-type dopant to facilitate injection of electrons from the cathode. In such a case, as the n-type dopant, alkali metal complex compounds known in the art may be used without limitation, and examples thereof may include alkali metals, alkaline earth metals, or rare earth metals.

The electron transport region 330 may be formed through a conventional method known in the art. For example, there may be a vacuum deposition method, a spin coating method, a casting method, a Langmuir-Blodgett (LB) method, an inkjet printing method, a laser printing method, a laser induced thermal imaging (LITI) method, and the like, but embodiments are not limited thereto.

4) Light-emitting auxiliary layer

Optionally, the organic EL device 100 of the present invention may further include a light-emitting auxiliary layer (not illustrated) disposed between the hole transport region 310 and the light-emitting layer 320.

The light-emitting auxiliary layer serves to control a thickness of the organic layer 300, while transporting holes migrating from the hole transport region 310 to the light-emitting layer 320, or blocking migration of electrons and/or excitons. In particular, the light-emitting auxiliary layer has a high LUMO value to prevent electrons from migrating to the hole transport layer 312 (or the hole transport auxiliary layer 313), and has a high triplet energy to prevent excitons of the light-emitting layer 320 from being diffused to the hole transport layer 312 (or the hole transport auxiliary layer 313).

The light-emitting auxiliary layer may include a hole transport material and may include or be formed of a material the same as a material of the hole transport region. In addition, the light-emitting auxiliary layers of the red, green, and blue organic EL devices may include or be formed of the same material.

A material for the light-emitting auxiliary layer is not particularly limited, and examples thereof may include carbazole derivatives and arylamine derivatives. Specifically, examples of the light-emitting auxiliary layer may include NPD (N,N-dinaphthyl-N,N'-diphenyl benzidine), TPD (N,N'-bis-(3-methylphenyl)-N,N'-bis(phenyl)-benzidine), s-TAD, MTDATA (4,4',4"-Tris(N-3-methylphenyl-Nphenyl-amino)-triphenylamine), and the like, but embodiments are not limited thereto. These may be used solely or two or more of them may be used in combination with each other.

The light-emitting auxiliary layer may further include a p-type dopant in addition to the above-described material. As the applicable p-type dopant according to the present invention, any known p-type dopant generally used in the art may be used without particular limitation. In such a case, a content of the p-type dopant may be appropriately adjusted within a range known in the art, for example, in a range of about 0.5 to 50 parts by weight with respect to 100 parts by weight of the hole transport material.

The light-emitting auxiliary layer may be formed by a vacuum deposition method, a spin coating method, a casting method, a Langmuir-Blodgett (LB) method, an inkjet printing method, a laser printing method, a laser induced thermal imaging (LITI) method, and the like known in the art, but embodiments are not limited thereto.

(4) Capping layer

Optionally, the organic EL device 100 of the present invention may further include a capping layer (not illustrated) disposed on the above-described cathode 200.

The capping layer may serve to allow light generated in the organic layer to be efficiently emitted to the outside while protecting the organic EL device.

The capping layer may include at least one of tris-8-hydroxyquinoline aluminum ($Alq_3$), ZnSe, 2,5-bis(6'- (2',2"-bipyridyl))-1,1-dimethyl-3,4-diphenylsilole, 4'-bis[N-(1-napthyl)-N- phenyl-amion] biphenyl ($\alpha$-NPD), N,N'-diphenyl-N,N'-bis(3-methylphenyl) -1,1'-biphenyl-4,4'-diamine (TPD), and 1,1'-bis(di-4-tolylaminophenyl) cyclohexane (TAPC). The material for forming such a capping layer is inexpensive as compared to materials of other layers of the organic EL device.

The capping layer may be a single layer, but may include two or more layers having different refractive indices so that the refractive index gradually changes while passing through the two or more layers.

The capping layer may be prepared by a conventional method known in the art, and for example, various methods such as a vacuum deposition method, a spin coating method, a casting method, or a Langmuir-Blodgett (LB) method may be used.

As such, the organic EL device according to the present invention has a structure in which the anode 100, the organic layer 300 and the cathode 200 are sequentially stacked. In some cases, an insulating layer (not illustrated) or an adhesive layer (not illustrated) may be further included between the anode 100 and the organic layer 300 or between the cathode 200 and the organic layer 300. The organic EL device of the present invention may have excellent lifespan characteristics because a half-life time of initial brightness is increased while maintaining maximum luminous efficiency when voltage and current are applied.

The organic EL device of the present invention described above may be prepared according to a conventional method known in the art. For example, after vacuum deposition of an anode material on a substrate, a hole transport region material, a light-emitting layer material, an electron transport region material, and a cathode material may be vacuum-deposited on the anode, and thus an organic EL device may be manufactured.

Hereinafter, the present invention will be described in detail through embodiments, but the following embodiments are merely illustrative of the present invention, and the present invention is not limited by the following embodiments. Preparation Examples 1, 4, 5, 7, 12, are not according to the present invention, while Preparation examples 2, 3, 6, 8, 9, 10, 11, 13 and 14 are according to the present invention.

[Preparation Examples 1 to 14] Measurement of HOMO, LUMO and triplet energy of Compounds 1 to 20

The following Compounds 1 to 14 were prepared as materials of the first host and the electron transport auxiliary layer of the present invention, and their HOMO and LUMO were measured by methods known in the art, respectively, which are shown in Table 1 below. In such a case, ADN and $Alq_3$ were used as controls. In Table 1, the HOMO energy level and the LUMO energy level are each described as absolute values.

1) HOMO energy level

A HOMO energy level of each compound was measured by cyclic voltammetry (CV) method.

2) LUMO energy level

After obtaining a bandgap energy of each compound as a UV spectrum, a LUMO energy level was obtained from a difference between the bandgap energy and the HOMO energy level.

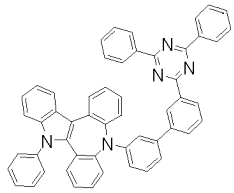
1

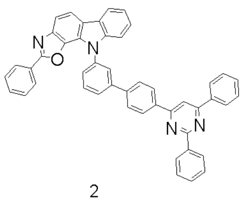
2

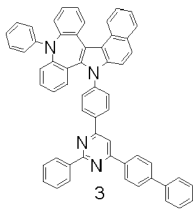
3

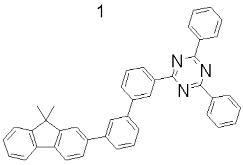
4

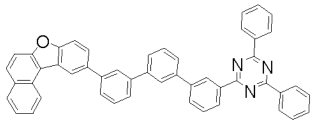
5

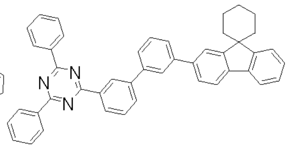
6

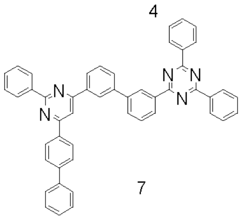
7

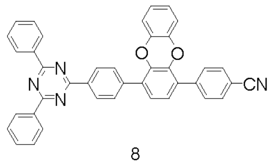
8

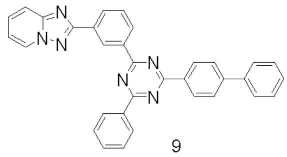
9

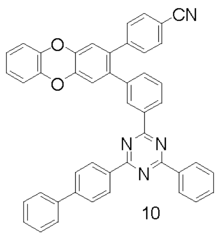
10

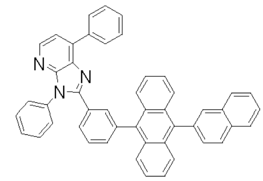
11

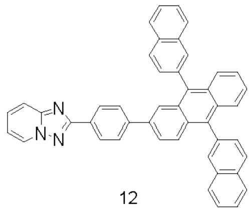
12

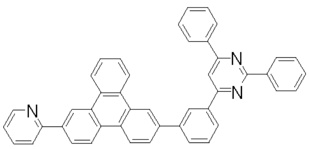
13

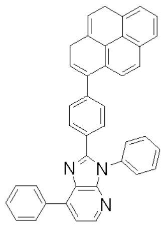
14

[Table 1]

| Compound | HOMO (eV) | LUMO (eV) |
|---|---|---|
| 1 | 5.97 | 2.67 |
| 2 | 5.82 | 2.67 |
| 3 | 5.84 | 2.71 |
| 4 | 5.83 | 2.64 |
| 5 | 6.02 | 2.64 |
| 6 | 5.82 | 2.67 |
| 7 | 6.25 | 2.75 |
| 8 | 5.85 | 2.76 |

(continued)

| Compound | HOMO (eV) | LUMO (eV) |
|---|---|---|
| 9 | 6.22 | 2.65 |
| 10 | 5.83 | 2.71 |
| 11 | 5.81 | 2.75 |
| 12 | 5.82 | 2.79 |
| 13 | 5.98 | 2.77 |
| 14 | 6.05 | 2.67 |
| ADN | 5.80 | 2.62 |
| $Alq_3$ | 5.62 | 2.80 |

[Embodiment 1] - Manufacturing of blue organic EL device

After high-purity sublimation purification of Compound 1 prepared in Preparation Example 1 (not according to the present invention) by a commonly known method, a blue organic EL device was prepared according to the following procedure.

First, a glass substrate that had been thin-film-coated with indium tin oxide (ITO) to a thickness of 1500 Å was washed ultrasonically with distilled water. After washing with distilled water was completed, the glass substrate was ultrasonically cleaned with a solvent, such as isopropyl alcohol, acetone and methanol, dried, transferred to a UV OZONE cleaner (Power sonic 405, Hwasin Tech), and cleaned for 5 minutes using UV, and then, the glass substrate was transferred to a vacuum evaporator.

On the ITO transparent electrode prepared as above, DS-205 (Doosan Corporation Electro-Materials) (80 nm) / NPB (15 nm) / Compound 1 + ADN + 5 % DS-405 (Doosan Corporation Electro-Materials) (30 nm) / Compound 1 (5 nm) / $Alq_3$ (25 nm) / LiF (1 nm) / Al (200 nm) were stacked in the order, and thus an organic EL device was manufactured. In such a case, the structures ofNPB, ADN, and $Alq_3$ used are as follows. In such a case, in the light-emitting layer, Compound 1 was used as the first host ('A' in the table 1), and ADN was used as the second host ('B' in the table 1).

[Embodiments 1, 4, 5, 7, 12 not according to the present invention, while 2, 3, 6, 8, 9, 10, 11, 13 and 14 according to the present invention]

- Manufacturing of blue organic EL device

Blue organic EL devices of Embodiments 2 to 14 were manufactured in the same manner as in Embodiment 1, except that each compound ('A') shown in Table 2 was used instead of Compound 1 which is the first host used in the formation of the light-emitting layer of Embodiment 1, and that each compound ('C') shown in Table 2 was used instead of Compound 1 used in the formation of the electron transport auxiliary layer.

[Comparative Example 1] - Manufacturing of blue organic EL device

A blue organic EL device was prepared in the same manner as in Embodiment 1, except that Compound 1 which is the first host was not used, and that only ADN which was the second host was used in the formation of the light-emitting layer of Embodiment 1.

[Comparative Example 2] - Manufacturing of blue organic EL device

A blue organic EL device was manufactured in the same manner as in Embodiment 1, except that only Compound 1 which is the first host was used and ADN which is the second host was not used in the formation of the light-emitting layer of Embodiment 1, the electron transport auxiliary layer was not formed, and the electron transport layer material $Alq_3$ was deposited to 30 nm instead of 25 nm.

[Comparative Example 3] - Manufacturing of blue organic EL device

A blue organic EL device was manufactured in the same manner as in Embodiment 1, except that Compound 1 which is the first host was not used and only AND which is the second host was used in the formation of the light-emitting

layer of Embodiment 1, the electron transport auxiliary layer was not formed, and the electron transport layer material $Alq_3$ was deposited to 30 nm instead of 25 nm.

[Evaluation Example 1 not according to the present invention]

For the organic EL devices prepared in Embodiments (Em.) 1 to 4 and Comparative Examples (Comp. Ex.) 1 to 3, a driving voltage, an emission wavelength, and a current efficiency were measured at a current density of 10 $mA/cm^2$, respectively, and the results are shown in Table 2 below.

[Table 2]

| Sample | Light-emitting layer material | | | Electron transport auxiliary layer material (C) | Driving voltage (V) | Emission peak (nm) | Current efficiency (cd/A) |
|---|---|---|---|---|---|---|---|
| | A | B | Weight ratio (A:B:DS-405) | | | | |
| Em. 1 | 1 | ADN | 50 : 50 : 5 | 1 | 4.2 | 456 | 7.4 |
| Em. 2 | 2 | ADN | 50 : 50 : 5 | 2 | 4.1 | 452 | 7.0 |
| Em. 3 | 3 | ADN | 50 : 50 : 5 | 3 | 4.1 | 450 | 7.8 |
| Em. 4 | 4 | ADN | 50 : 50 : 5 | 4 | 3.8 | 452 | 7.5 |
| Em. 5 | 5 | ADN | 50 : 50 : 5 | 5 | 3.7 | 455 | 7.2 |
| Em. 6 | 6 | ADN | 50 : 50 : 5 | 6 | 4.0 | 452 | 8.0 |
| Em. 7 | 7 | ADN | 50 : 50 : 5 | 7 | 4.0 | 455 | 8.0 |
| Em. 8 | 8 | ADN | 50 : 50 : 5 | 8 | 3.9 | 455 | 7.7 |
| Em. 9 | 9 | ADN | 50 : 50 : 5 | 9 | 4.1 | 452 | 7.6 |
| Em. 10 | 10 | ADN | 50 : 50 : 5 | 10 | 4.1 | 455 | 7.5 |
| Em. 11 | 11 | ADN | 50 : 50 : 5 | 11 | 3.7 | 455 | 8.1 |
| Em. 12 | 12 | ADN | 50 : 50 : 5 | 12 | 3.7 | 458 | 7.1 |
| Em. 13 | 13 | ADN | 50 : 50 : 5 | 13 | 3.8 | 455 | 7.6 |
| Em. 14 | 14 | ADN | 50 : 50 : 5 | 14 | 4.2 | 456 | 7.8 |
| Comp. Ex. 1 | - | ADN | 0 : 100 : 5 | 1 | 4.8 | 458 | 6.2 |
| Comp. Ex. 2 | 1 | - | 100 : 0 : 5 | - | 5.0 | 455 | 6.0 |
| Comp. Ex. 3 | - | ADN | 0 : 100 : 5 | - | 5.2 | 457 | 6.4 |

Referring to Table 2, it was appreciated that the blue organic EL devices of Embodiments 1, 4, 5, 7, 12 not according to the present invention, while embodiments 2, 3, 6, 8, 9, 10, 11, 13 and 14 according to the present invention in which one of the plurality of hosts in the light-emitting layer includes a material the same as a material included in the electron transport auxiliary layer achieved excellent performance in terms of the driving voltage, the emission peak and the current efficiency as compared to Comparative Examples 1 to 3.

## Claims

**1.** An organic electroluminescent device comprising:

an anode (100);
a cathode (200) disposed opposing the anode (100); and
an organic layer (300) disposed between the anode (100) and the cathode (200) and comprising a hole transport region (310) , a light-emitting layer (320), and an electron transport region (330) sequentially disposed on the anode,
wherein the electron transport region (330) comprises an electron transport auxiliary layer (331), an electron transport layer (332) and an electron injection layer (333) sequentially disposed on the light-emitting layer (320),

the light-emitting layer (320) comprises a plurality of hosts and dopants, **characterized in that** one of the plurality of hosts comprises a material the same as a material of the electron transport auxiliary layer, wherein a material of the electron transport auxiliary layer comprises a compound represented by any one of the following Chemical Formulas A-1 to A-16:

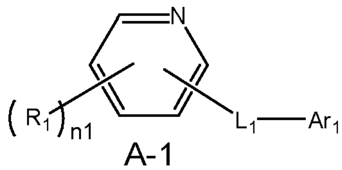
A-1
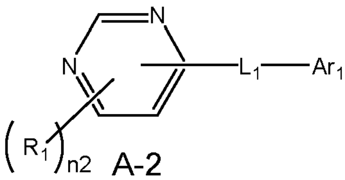
A-2
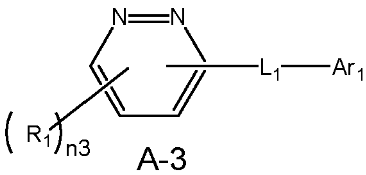
A-3
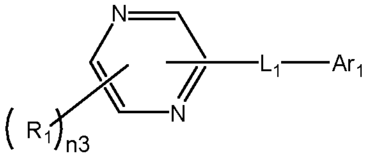
A-4
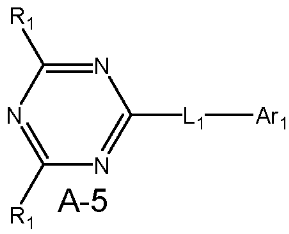
A-5
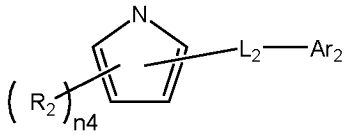
A-6
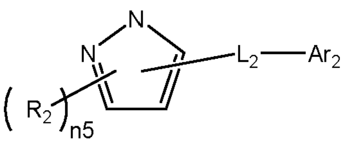
A-7
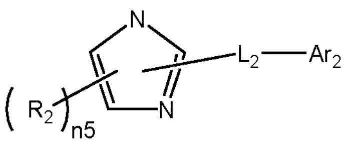
A-8
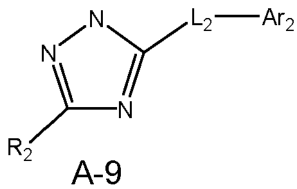
A-9
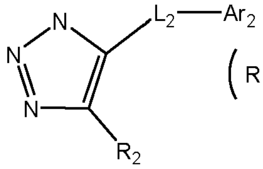
A-10
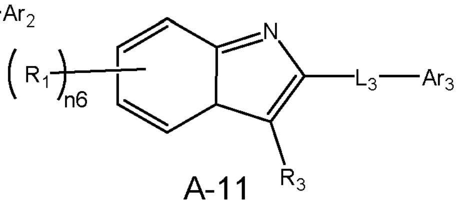
A-11
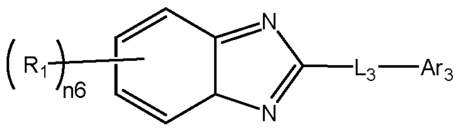
A-12
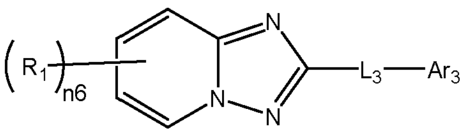
A-13
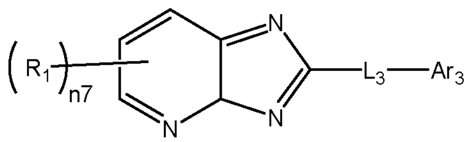
A-14
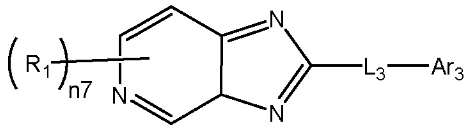
A-15
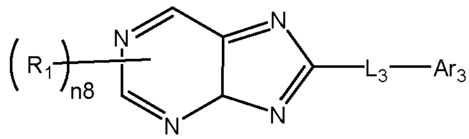
A-16

wherein in Chemical Formulas A-1 to A-16,
n1 and n6 are each an integer in a range of 0 to 4,
n2, n3, n4, and n7 are each an integer in a range of 0 to 3, and
n5 and n8 are each an integer in a range of 0 to 2,
$R_1$ and $R_2$ are the same as or different from each other, each independently being selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40

nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or forming a fused ring with an adjacent group, and the alkyl group, the alkenyl group, the alkynyl group, the aryl group, the heteroaryl group, the aryloxy group, the alkyloxy group, the cycloalkyl group, the heterocycloalkyl group, the arylsilyl group, the alkylsilyl group, the alkylboron group, the arylboron group, the phosphine group, and the phosphine oxide group of $R_1$ and $R_2$ are each independently substituted or unsubstituted with one or more substituents of: hydrogen, deuterium, a halogen group, a cyano group, a nitro group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, and when the substituents are plural in number, the substituents are the same as or different from each other,

$L_1$ to $L_3$ are the same as or different from each other, each independently being a single bond, or being selected from: a $C_6$ to $C_{18}$ arylene group and a heteroarylene group having 5 to 18 nuclear atoms,

in Chemical Formulas A-1, A-6 to A-12, A-14 to A-16, $Ar_1$ to $Ar_3$ are the same as or different from each other, each independently being a substituent selected from substituents represented by the following Chemical Formulas S1 to S9,

in Chemical Formulas A-2 to A-4, $Ar_1$ is a substituent selected from substituents represented by the following Chemical Formulas S1, S2 and S4 to S9,

in Chemical Formulas A-5, $Ar_1$ is a substituent selected from substituents represented by the following Chemical Formulas S2 and S4 to S9,

in Chemical Formula A-13, $Ar_3$ is a substituent selected from substituents represented by the following Chemical Formulas S1 to S3 and S5 to S9,

in Chemical Formulas A-2 to A-4, when $Ar_1$ is substituent represented by the following Chemical Formula S3, $L_1$ is selected from a $C_6$ to $C_{18}$ arylene group and a heteroarylene group having 5 to 18 nuclear atoms:

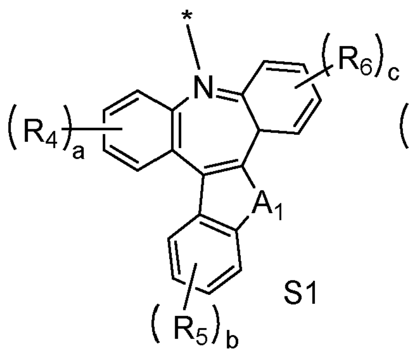
S1

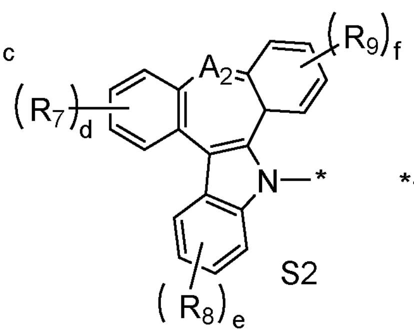
S2

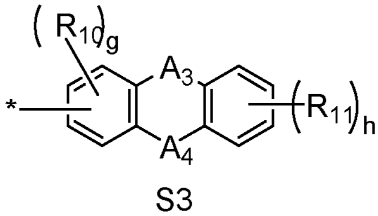
S3

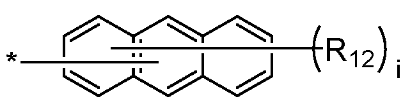
S4

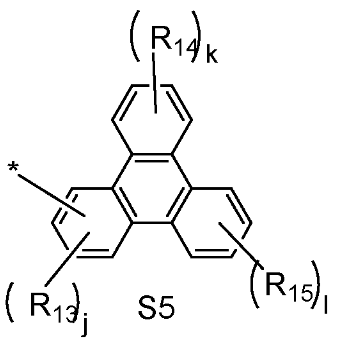
S5

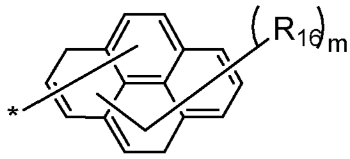
S6

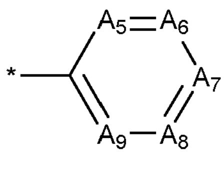

S7

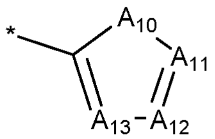

S8

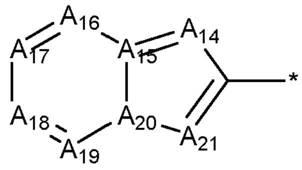

S9

in Chemical Formulas S1 to S9,

$A_1$ and $A_2$ are N or $CR_{17}$,

$A_3$ and $A_4$ are the same as or different from each other, each independently being a single bond, or being selected from: $NR_{18}$, O, S, and $CR_{19}R_{20}$, wherein a case where both of $A_3$ and $A_4$ are single bonds is excluded,

$A_5$ to $A_9$ are N or $CR_{21}$, wherein at least one of $A_5$ to $A_9$ is N, and when $CR_{21}$ is plural in number, the plurality of $R_{21}$ are the same as or different from each other,

$A_{10}$ to $A_{13}$ are N or $CR_{22}$, wherein at least one of $A_{10}$ to $A_{13}$ is N, and when $CR_{22}$ is plural in number, the plurality of $R_{22}$ are the same as or different from each other,

$A_{14}$ to $A_{21}$ are N or $CR_{23}$, wherein at least one of $A_{14}$ to $A_{21}$ is N, and when $CR_{23}$ is plural in number, the plurality of $R_{23}$ are the same as or different from each other,

a, b, c, d, e, f, h, k, and l are each an integer in a range of 0 to 4;

g and j are each an integer in a range of 0 to 3,

i and m are each an integer in a range of 0 to 9,

$R_4$ to $R_{23}$ are the same as or different from each other, each independently being selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or forming a fused ring with an adjacent group, and the alkyl group, the alkenyl group, the alkynyl group, the aryl group, the heteroaryl group, the aryloxy group, the alkyloxy group, the cycloalkyl group, the heterocycloalkyl group, the arylsilyl group, the alkylsilyl group, the alkylboron group, the arylboron group, the phosphine group, and the phosphine oxide group of $R_4$ to $R_{23}$ are each independently substituted or unsubstituted with one or more substituents of: hydrogen, deuterium, a halogen group, a cyano group, a nitro group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, and when the substituents are plural in number, the substituents are the same as or different from each other.

**2.** The organic electroluminescent device of claim 1, wherein the electron transport auxiliary layer (331) satisfies the following Relational Expression 3:

[Relational Expression 3]

$$|HOMO_{aETL}| > |HOMO_{EL}|$$

wherein

$HOMO_{aETL}$ is a HOMO energy level of the electron transport auxiliary layer (331), and
$HOMO_{EL}$ is a HOMO energy level of the light-emitting layer (320) wherein the HOMO level was measured by cyclic voltammetry .

**3.** The organic electroluminescent device of claim 2, wherein a difference between an absolute value of the HOMO energy level of the electron transport auxiliary layer (331) and an absolute value of the HOMO energy level of the light-emitting layer (320) is in a range of greater than 0 eV to 1.0 eV or less.

**4.** The organic electroluminescent device of claim 1, wherein the electron transport auxiliary layer (331) satisfies the

following Relational Expression 4:

[Relational Expression 4]

$$|LUMO_{ETL}| > |LUMO_{aETL}| > |LUMO_{EL}|$$

wherein

$LUMO_{ETL}$ is a LUMO energy level of the electron transport layer (332),
$LUMO_{aETL}$ is a LUMO energy level of the electron transport auxiliary layer (331), and
$LUMO_{EL}$ is a LUMO energy level of the light-emitting layer (320) wherein the LUMO level was measured by cyclic voltammetry and UV spectrometry.

**5.** The organic electroluminescent device of claim 4, wherein a difference between an absolute value of the LUMO energy level of the electron transport auxiliary layer (331) and an absolute value of the LUMO energy level of the electron transport layer (332) is in a range of greater than 0 eV to 1.0 eV or less.

**6.** The organic electroluminescent device of claim 4, wherein a difference between an absolute value of the LUMO energy level of the electron transport auxiliary layer (331) and an absolute value of the LUMO energy level of the light-emitting layer (320) is in a range of greater than 0 eV to 1.0 eV or less.

**7.** The organic electroluminescent device of claim 1, wherein the compound represented by any one of Chemical Formulas A-1 to A-16 is selected from the following Chemical Formulas B-1 to B-6, B-8, and B-9:

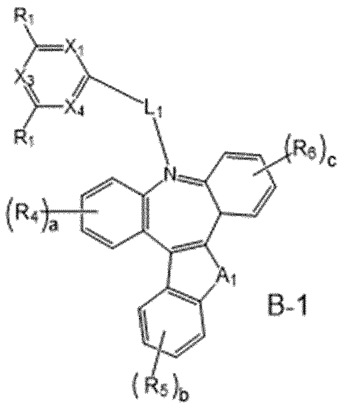
B-1

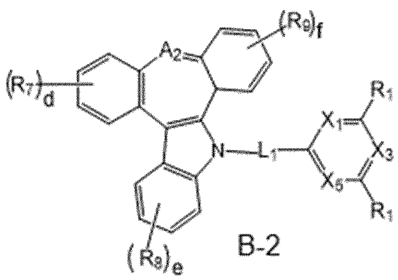
B-2

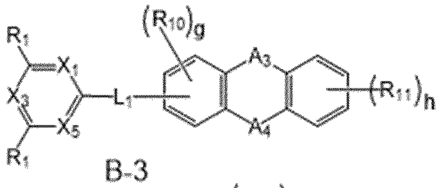
B-3

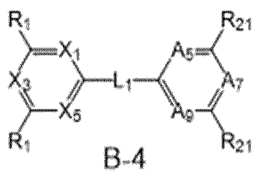
B-4

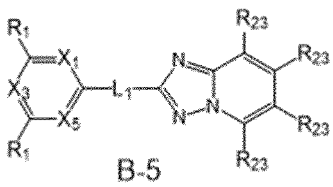
B-5

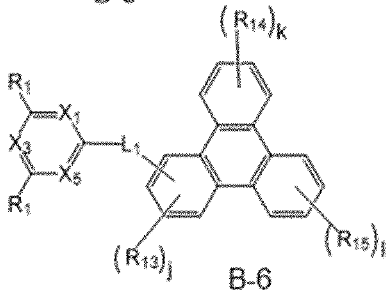
B-6

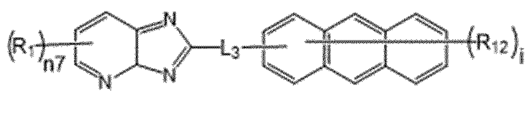

B-8

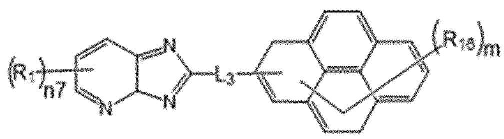

B-9

in Chemical Formulas B-1, $X_1$, $X_3$, and $X_5$ are the same as or different from each other, each independently being N or C($R_1$), wherein one or two of $X_1$, $X_3$, and $X_5$ is N,
in Chemical Formulas B-2, B-4 to B-6, $X_1$, $X_3$, and $X_5$ are the same as or different from each other, each independently being N or C($R_1$), wherein at least one of $X_1$, $X_3$, and $X_5$ is N,
in Chemical Formulas B-3, $X_1$, $X_3$, and $X_5$ are the same as or different from each other, each independently being N or C($R_1$), wherein one of $X_1$, $X_3$, and $X_5$ is N,
wherein in Chemical Formulas B-1 to B-6, B-8, and B-9,
the plurality of $R_1$ are the same as or different from each other, each independently being selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or forming a fused ring with an adjacent group,
the alkyl group, the alkenyl group, the alkynyl group, the aryl group, the heteroaryl group, the aryloxy group, the alkyloxy group, the cycloalkyl group, the heterocycloalkyl group, the arylsilyl group, the alkylsilyl group, the alkylboron group, the arylboron group, the phosphine group, and the phosphine oxide group of $R_1$ are each independently substituted or unsubstituted with one or more substituents of: hydrogen, deuterium, a halogen group, a cyano group, a nitro group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, and when the substituents are plural in number, the substituents are the same as or different from each other,
wherein in Chemical Formulas B-1, B-2, B-4 to B-6, B-8, and B-9, $L_1$ and $L_3$ are the same as or different from each other, each independently being a single bond, or being selected from: a $C_6$ to $C_{18}$ arylene group and a heteroarylene group having 5 to 18 nuclear atoms,
wherein in Chemical Formulas B-3, $L_3$ is selected from: a $C_6$ to $C_{18}$ arylene group and a heteroarylene group having 5 to 18 nuclear atoms,
$A_1$ and $A_2$ are N or $CR_{17}$,
$A_3$ and $A_4$ are the same as or different from each other, each independently being a single bond, or being selected from: $NR_{18}$, O, S, and $CR_{19}R_{20}$, wherein a case where both of $A_3$ and $A_4$ are single bonds is excluded,
$A_5$, $A_7$, and $A_9$ are N or $CR_{21}$, wherein at least one of $A_5$, $A_7$, and $A_9$ is N, and when $CR_{21}$ is plural in number, the plurality of $R_{21}$ are the same as or different from each other,
a, b, c, d, e, f, h, k, and l are each an integer in a range of 0 to 4;
g and j are each an integer in a range of 0 to 3,
i and m are each an integer in a range of 0 to 9,
$n_6$ is an integer in a range of 0 to 4,
$n_7$ is an integer in a range of 0 to 3,
$R_4$ to $R_{23}$ are the same as or different from each other, each independently being selected from: hydrogen, deuterium, a halogen group, a cyano group, a nitro group, an amino group, a $C_1$ to $C_{40}$ alkyl group, a $C_2$ to $C_{40}$ alkenyl group, a $C_2$ to $C_{40}$ alkynyl group, a $C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, or forming a fused ring with an adjacent group, and
the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the phosphine group, and the phosphine oxide group of $R_4$ to $R_{23}$ are each independently substituted or unsubstituted with one or more substituents of: hydrogen, deuterium, a halogen group, a cyano group, a nitro group, a $C_1$ to $C_{40}$ alkyl group, a $C_2$ to $C_{40}$ alkenyl group, a $C_2$ to $C_{40}$ alkynyl group, a

$C_3$ to $C_{40}$ cycloalkyl group, a heterocycloalkyl group having 3 to 40 nuclear atoms, a $C_6$ to $C_{60}$ aryl group, a heteroaryl group having 5 to 60 nuclear atoms, a $C_1$ to $C_{40}$ alkyloxy group, a $C_6$ to $C_{60}$ aryloxy group, a $C_1$ to $C_{40}$ alkylsilyl group, a $C_6$ to $C_{60}$ arylsilyl group, a $C_1$ to $C_{40}$ alkylboron group, a $C_6$ to $C_{60}$ arylboron group, a $C_6$ to $C_{60}$ arylphosphine group, a $C_6$ to $C_{60}$ arylphosphine oxide group and a $C_6$ to $C_{60}$ arylamine group, and when the substituents are plural in number, the substituents are the same as or different from each other.

**8.** The organic electroluminescent device of claim 1, wherein the compound comprising the least one moiety is a compound represented by any one of the following Chemical Formulas 2, 3, 6, 8 to 11, 13, and 14:

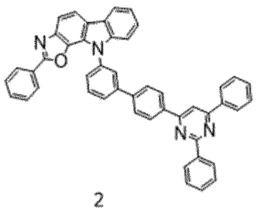
2

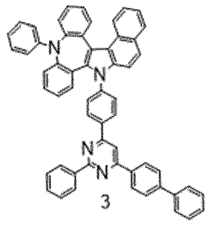
3

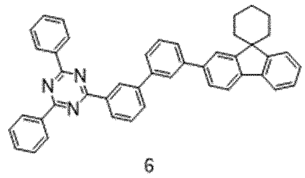
6

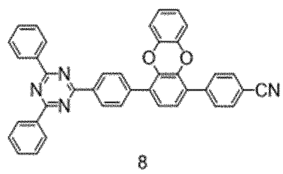
8

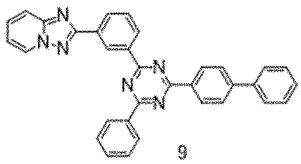
9

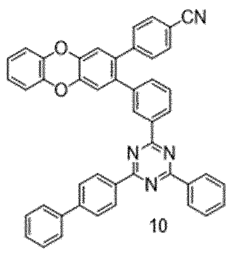
10

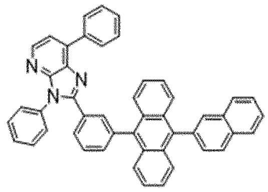
11

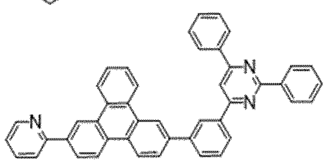
13

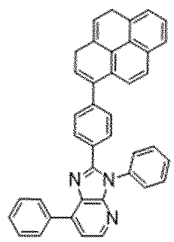
14

**9.** The organic electroluminescent device of claim 1, wherein a content of hosts the same as the material of the electron transport auxiliary layer from among the plurality of hosts is in a range of 30 to 90 percent by weight (wt%) with respect to the total amount of entire hosts.

**10.** The organic electroluminescent device of claim 1, wherein the plurality of hosts comprises:

a first host the same as the material of the electron transport auxiliary layer; and
a second host different from the first host and satisfying the following Relational Expressions 1 and 2:

[Relational Expression 1]

$$|LUMO_{host\text{-}1}| > |LUMO_{host\text{-}2}$$

[Relational Expression 2]

$$|HOMO_{host\text{-}1}| > |HOMO_{host\text{-}2}|$$

wherein in Relational Expressions 1 and 2,
$LUMO_{host\text{-}1}$ is a LUMO energy level of the first host,
$LUMO_{host\text{-}2}$ is a LUMO energy level of the second host,
$HOMO_{host\text{-}1}$ is a HOMO energy level of the first host, and
$HOMO_{host\text{-}2}$ is a HOMO energy level of the second host, wherein the HOMO and LUMO levels were measured by cyclic voltammetry and UV spectrometry.

**11.** The organic electroluminescent device of claim 10, wherein a difference between an absolute value of the LUMO energy level of the second host and an absolute value of the LUMO energy level of the first host is in a range of greater than 0 eV to 1.0 eV or less, and
a difference between an absolute value of the HOMO energy level of the second host and an absolute value of the HOMO energy level of the first host is in a range of greater than 0 eV to 1.0 eV or less.

**12.** The organic electroluminescent device of claim 10, wherein a use ratio of the first host and the second host is in a range of 30:70 to 90: 10 by weight.

**Patentansprüche**

**1.** Organische elektrolumineszente Vorrichtung, umfassend:

eine Anode (100);
eine Kathode (200), die entgegengesetzt zu der Anode (100) angeordnet ist; und
eine organische Schicht (300), die zwischen der Anode (100) und der Kathode (200) angeordnet ist, und eine Lochtransportregion (310), eine lichtemittierende Schicht (320) und eine Elektronentransportregion (330) umfasst, die sequenziell auf der Anode angeordnet sind,
wobei die Elektronentransportregion (330) eine Elektronentransporthilfsschicht (331), eine Elektronentransportschicht (332) und eine Elektroneninjektionsschicht (333) umfasst, die sequenziell auf der lichtemittierenden Schicht (320) angeordnet sind,
wobei die lichtemittierende Schicht (320) eine Vielzahl von Wirten und Dotiermitteln umfasst,
**dadurch gekennzeichnet, dass** einer der Vielzahl von Wirten ein Material umfasst, das mit einem Material der Elektronentransporthilfsschicht identisch ist,
wobei ein Material der Elektronentransporthilfsschicht eine Verbindung umfasst, die durch eine beliebige der folgenden chemischen Formeln A-1 bis A-16 dargestellt ist:

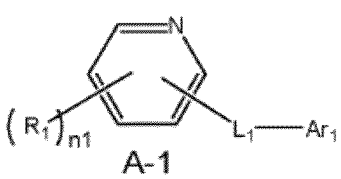
A-1

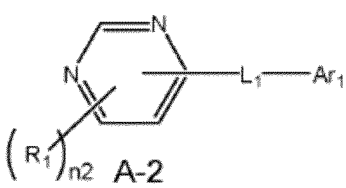
A-2

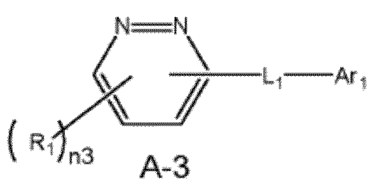
A-3

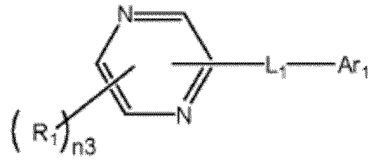

A-4

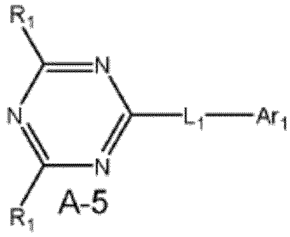

A-5

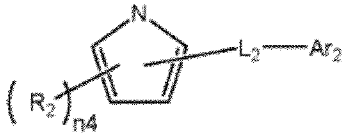

A-6

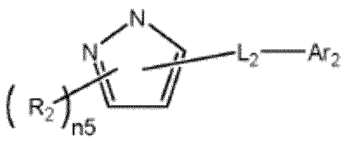

A-7

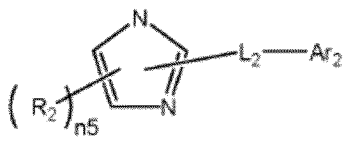

A-8

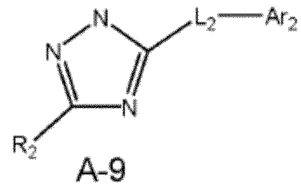

A-9

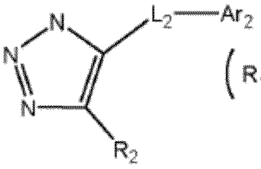

A-10

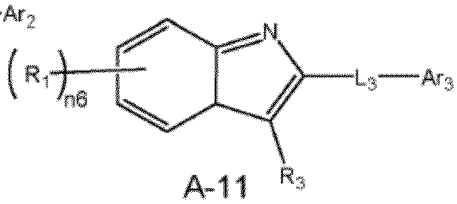

A-11

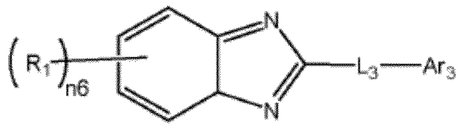

A-12

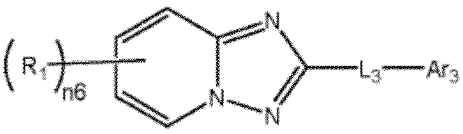

A-13

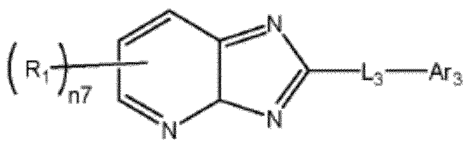

A-14

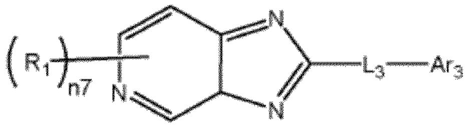

A-15

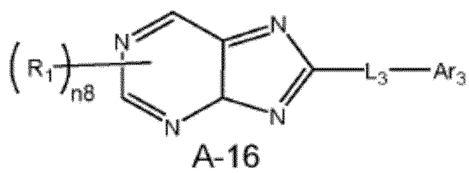

A-16

wobei in den chemischen Formeln A-1 bis A-16:

n1 und n6 jeweils eine ganze Zahl in einem Bereich von 0 bis 4 sind,
n2, n3, n4 und n7 jeweils eine ganze Zahl in einem Bereich von 0 bis 3 sind und
n5 und n8 jeweils eine ganze Zahl in einem Bereich von 0 bis 2 sind,
$R_1$ und $R_2$ gleich oder verschieden voneinander sind, wobei jedes unabhängig ausgewählt ist aus: Wasserstoff, Deuterium, einer Halogengruppe, einer Cyanogruppe, einer Nitrogruppe, einer Aminogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, oder einen anellierten Ring mit einer benachbarten Gruppe bilden, und die Alkylgruppe, die Alkenylgruppe, die Alkinylgruppe, die Arylgruppe, die Heteroarylgruppe, die Aryloxygruppe, die Alkyloxygruppe, die Cycloalkylgruppe, die Heterocycloalkylgruppe, die Arylsilylgruppe, die Alkylsilylgruppe, die Alkylborgruppe, die Arylborgruppe, die Phosphingruppe und die Phosphinoxidgruppe von $R_1$ und $R_2$ jeweils unabhängig substituiert oder unsubstituiert sind mit einem oder mehreren Substituenten von: Wasserstoff, Deuterium, einer Halogengruppe, einer Cyanogruppe, einer Nitrogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer

$C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, und wenn mehrere der Substituenten vorliegen, die Substituenten gleich oder verschieden voneinander sind,

$L_1$ bis $L_3$ gleich oder verschieden voneinander sind, wobei jedes unabhängig eine Einfachbindung ist oder ausgewählt ist aus: einer $C_6$- bis $C_{18}$-Arylengruppe und einer Heteroarylengruppe mit 5 bis 18 Kernatomen,

in den chemischen Formeln A-1, A-6 bis A-12, A-14 bis A-16 $Ar_1$ bis $Ar_3$ gleich oder verschieden voneinander sind, wobei jedes unabhängig ein Substituent ist, der aus Substituenten ausgewählt ist, die durch die folgenden chemischen Formeln S1 bis S9 dargestellt sind,

in den chemischen Formeln A-2 bis A-4 $Ar_1$ ein Substituent ist, der aus Substituenten ausgewählt ist, die durch die folgenden chemischen Formeln S1, S2 und S4 bis S9 dargestellt sind,

in den chemischen Formeln A-5 $Ar_1$ ein Substituent ist, der aus Substituenten ausgewählt ist, die durch die folgenden chemischen Formeln S2 und S4 bis S9 dargestellt sind,

in den chemischen Formeln A-13 $Ar_3$ ein Substituent ist, der aus Substituenten ausgewählt ist, die durch die folgenden chemischen Formeln S1 bis S3 und S5 bis S9 dargestellt sind,

in den chemischen Formeln A-2 bis A-4, wenn $Ar_1$ ein Substituent ist, der durch die folgende chemische Formel S3 dargestellt ist, $L_1$ aus einer $C_6$- bis $C_{18}$-Arylengruppe und einer Heteroarylengruppe mit 5 bis 18 Kernatomen ausgewählt ist:

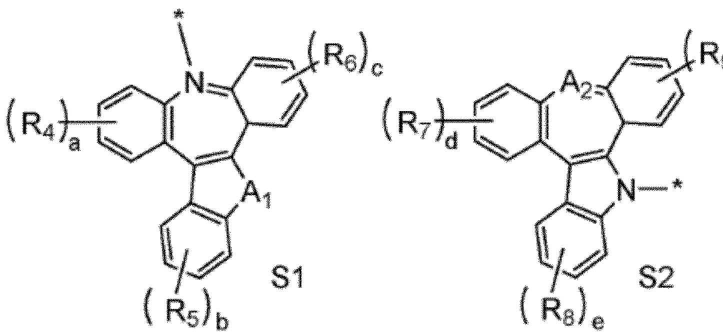

S1 S2

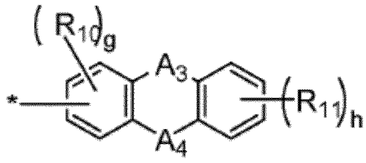

S3

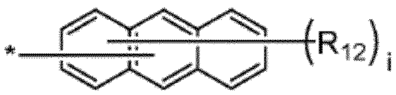

S4

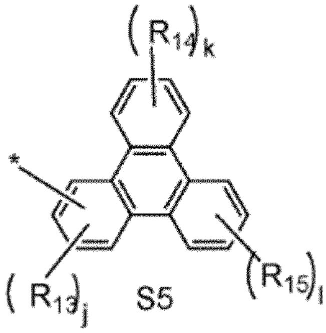

S5

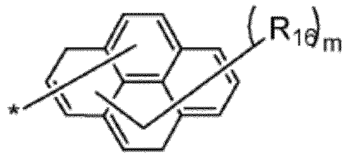

S6

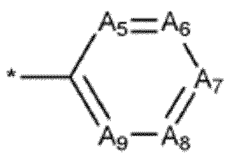

S7

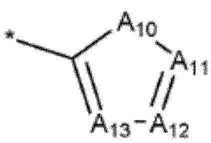

S8

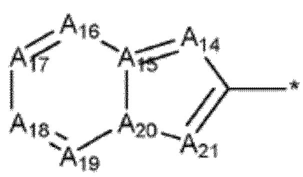

S9

in den chemischen Formeln S1 bis S9:

$A_1$ und $A_2$ N oder $CR_{17}$ sind,

$A_3$ und $A_4$ gleich oder verschieden voneinander sind, wobei jedes unabhängig eine Einfachbindung ist oder ausgewählt ist aus: $NR_{18}$, O, S und $CR_{19}R_{20}$, wobei ein Fall, in dem sowohl $A_3$ als auch $A_4$ Einfachbindungen sind, ausgeschlossen ist,

$A_5$ bis $A_9$ N oder $CR_{21}$ sind, wobei mindestens eines von $A_5$ bis $A_9$ N ist, und wenn mehrere $CR_{21}$ vorliegen, die Vielzahl von $R_{21}$ gleich oder verschieden voneinander sind,
$A_{10}$ bis $A_{13}$ N oder $CR_{22}$ sind, wobei mindestens eines von $A_{10}$ bis $A_{13}$ N ist, und wenn mehrere $CR_{22}$ vorliegen, die Vielzahl von $R_{22}$ gleich oder verschieden voneinander sind,
$A_{14}$ bis $A_{21}$ N oder $CR_{23}$ sind, wobei mindestens eines von $A_{14}$ bis $A_{21}$ N ist, und wenn mehrere $CR_{23}$ vorliegen, die Vielzahl von $R_{23}$ gleich oder verschieden voneinander sind,
a, b, c, d, e, f, h, k und l jeweils eine ganze Zahl in einem Bereich von 0 bis 4 sind;
g und j jeweils eine ganze Zahl in einem Bereich von 0 bis 3 sind,
i und m jeweils eine ganze Zahl in einem Bereich von 0 bis 9 sind,
$R_4$ bis $R_{23}$ gleich oder verschieden voneinander sind, wobei jedes unabhängig ausgewählt ist aus: Wasserstoff, Deuterium, einer Halogengruppe, einer Cyanogruppe, einer Nitrogruppe, einer Aminogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, oder einen anellierten Ring mit einer benachbarten Gruppe bilden, und die Alkylgruppe, die Alkenylgruppe, die Alkinylgruppe, die Arylgruppe, die Heteroarylgruppe, die Aryloxygruppe, die Alkyloxygruppe, die Cycloalkylgruppe, die Heterocycloalkylgruppe, die Arylsilylgruppe, die Alkylsilylgruppe, die Alkylborgruppe, die Arylborgruppe, die Phosphingruppe und die Phosphinoxidgruppe von $R_4$ bis $R_{23}$ jeweils unabhängig substituiert oder unsubstituiert sind mit einem oder mehreren Substituenten von: Wasserstoff, Deuterium, einer Halogengruppe, einer Cyanogruppe, einer Nitrogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, und wenn mehrere der Substituenten vorliegen, die Substituenten gleich oder verschieden voneinander sind.

**2.** Organische elektrolumineszente Vorrichtung nach Anspruch 1, wobei die Elektronentransporthilfsschicht (331) dem folgenden Vergleichsausdruck 3 genügt:

[Vergleichsausdruck 3]

$$|HOMO_{aETL}| > |HOMO_{EL}|,$$

wobei

$HOMO_{aETL}$ ein HOMO-Energieniveau der Elektronentransporthilfsschicht (331) ist und
$HOMO_{EL}$ ein HOMO-Energieniveau der lichtemittierenden Schicht (320) ist, wobei das HOMO-Niveau durch zyklische Voltammetrie gemessen wurde.

**3.** Organische elektrolumineszente Vorrichtung nach Anspruch 2, wobei ein Unterschied zwischen einem Absolutwert des HOMO-Energieniveaus der Elektronentransporthilfsschicht (331) und einem Absolutwert des HOMO-Energieniveaus der lichtemittierenden Schicht (320) in einem Bereich von mehr als 0 eV bis 1,0 eV oder weniger liegt.

**4.** Organische elektrolumineszente Vorrichtung nach Anspruch 1, wobei die Elektronentransporthilfsschicht (331) dem folgenden Vergleichsausdruck 4 genügt:

[Vergleichsausdruck 4]

$$|LUMO_{ETL}| > |LUMO_{aETL}| > |LUMO_{EL}|,$$

wobei

$LUMO_{ETL}$ ein LUMO-Energieniveau der Elektronentransportschicht (332) ist,
$LUMO_{aETL}$ ein LUMO-Energieniveau der Elektronentransporthilfsschicht (331) ist und
$LUMO_{EL}$ ein LUMO-Energieniveau der lichtemittierenden Schicht (320) ist, wobei das LUMO-Niveau durch zyklische Voltammetrie und UV-Spektrometrie gemessen wurde.

**5.** Organische elektrolumineszente Vorrichtung nach Anspruch 4, wobei ein Unterschied zwischen einem Absolutwert des LUMO-Energieniveaus der Elektronentransporthilfsschicht (331) und einem Absolutwert des LUMO-Energieniveaus der Elektronentransportschicht (332) in einem Bereich von mehr als 0 eV bis 1,0 eV oder weniger liegt.

**6.** Organische elektrolumineszente Vorrichtung nach Anspruch 4, wobei ein Unterschied zwischen einem Absolutwert des LUMO-Energieniveaus der Elektronentransporthilfsschicht (331) und einem Absolutwert des LUMO-Energieniveaus der lichtemittierenden Schicht (320) in einem Bereich von mehr als 0 eV bis 1,0 eV oder weniger liegt.

**7.** Organische elektrolumineszente Vorrichtung nach Anspruch 1, wobei die Verbindung, die durch eine beliebige der chemischen Formeln A-1 bis A-16 dargestellt ist, aus den folgenden chemischen Formeln B-1 bis B-6, B-8 und B-9 ausgewählt ist:

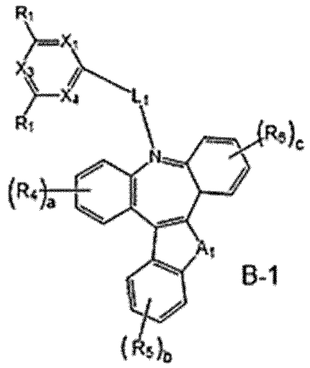

B-1

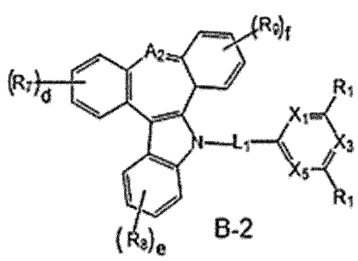

B-2

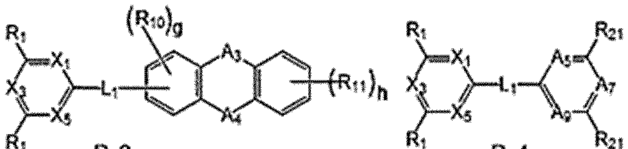

B-3

B-4

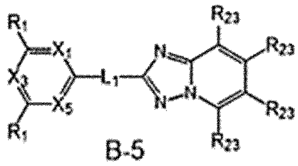

B-5

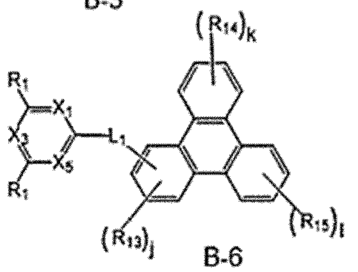

B-6

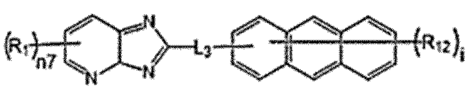

B-8

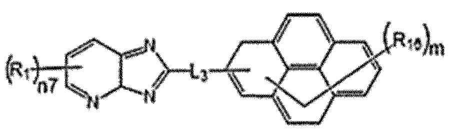

B-9

wobei in den chemischen Formeln B-1 $X_1$, $X_3$ und $X_5$ gleich oder verschieden voneinander sind, wobei jedes unabhängig N oder $C(R_1)$ ist, wobei eines oder zwei von $X_1$, $X_3$ und $X_5$ N ist bzw. sind,
in den chemischen Formeln B-2, B-4 bis B-6 $X_1$, $X_3$ und $X_5$ gleich oder verschieden voneinander sind, wobei jedes unabhängig N oder $C(R_1)$ ist, wobei mindestens eines von $X_1$, $X_3$ und $X_5$ N ist,
in den chemischen Formeln B-3 $X_1$, $X_3$ und $X_5$ gleich oder verschieden voneinander sind, wobei jedes unabhängig N oder $C(R_1)$ ist, wobei eines von $X_1$, $X_3$ und $X_5$ N ist,
wobei in den chemischen Formeln B-1 bis B-6, B-8 und B-9

die Vielzahl von $R_1$ gleich oder verschieden voneinander sind, wobei jedes unabhängig ausgewählt ist aus: Wasserstoff, Deuterium, einer Halogengruppe, einer Cyanogruppe, einer Nitrogruppe, einer Aminogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, oder einen anellierten Ring mit einer benachbarten Gruppe bildet, die Alkylgruppe, die Alkenylgruppe, die Alkinylgruppe, die Arylgruppe, die Heteroarylgruppe, die Aryloxygruppe, die Alkyloxygruppe, die Cycloalkylgruppe, die Heterocycloalkylgruppe, die Arylsilylgruppe, die Alkylsilylgruppe, die Alkylborgruppe, die Arylborgruppe, die Phosphingruppe und die Phosphinoxidgruppe von $R_1$ jeweils unabhängig substituiert oder unsubstituiert sind mit einem oder mehreren Substituenten von: Wasserstoff, Deuterium, einer Halogengruppe, einer Cyanogruppe, einer Nitrogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, und wenn mehrere der Substituenten vorliegen, die Substituenten gleich oder verschieden voneinander sind,
wobei in den chemischen Formeln B-1, B-2, B-4 bis B-6, B-8 und B-9 $L_1$ und $L_3$ gleich oder verschieden voneinander sind, wobei jedes unabhängig eine Einfachbindung ist oder ausgewählt ist aus: einer $C_6$- bis $C_{18}$-Arylengruppe und einer Heteroarylengruppe mit 5 bis 18 Kernatomen,
wobei in den chemischen Formeln B-3 L3 ausgewählt ist aus: einer $C_6$- bis $C_{18}$-Arylengruppe und einer Heteroarylengruppe mit 5 bis 18 Kernatomen,
$A_1$ und $A_2$ N oder $CR_{17}$ sind,
$A_3$ und $A_4$ gleich oder verschieden voneinander sind, wobei jedes unabhängig eine Einfachbindung ist oder ausgewählt ist aus: $NR_{18}$, O, S und $CR_{19}R_{20}$, wobei ein Fall, in dem sowohl $A_3$ als auch $A_4$ Einfachbindungen sind, ausgeschlossen ist,
$A_5$, $A_7$ und $A_9$ N oder $CR_{21}$ sind, wobei mindestens eines von $A_5$, $A_7$ und $A_9$ N ist, und wenn mehrere $CR_{21}$ vorliegen, die Vielzahl von $R_{21}$ gleich oder verschieden voneinander sind,
a, b, c, d, e, f, h, k und l jeweils eine ganze Zahl in einem Bereich von 0 bis 4 sind;
g und j jeweils eine ganze Zahl in einem Bereich von 0 bis 3 sind,
i und m jeweils eine ganze Zahl in einem Bereich von 0 bis 9 sind,
$n_6$ eine ganze Zahl in einem Bereich von 0 bis 4 ist,
$n_7$ eine ganze Zahl in einem Bereich von 0 bis 3 ist,
$R_4$ bis $R_{23}$ gleich oder verschieden voneinander sind, wobei jedes unabhängig ausgewählt ist aus: Wasserstoff, Deuterium, einer Halogengruppe, einer Cyanogruppe, einer Nitrogruppe, einer Aminogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, oder einen anellierten Ring mit einer benachbarten Gruppe bilden, und
die Alkylgruppe, die Alkenylgruppe, die Alkinylgruppe, die Arylgruppe, die Heteroarylgruppe, die Aryloxygruppe, die Alkyloxygruppe, die Cycloalkylgruppe, die Heterocycloalkylgruppe, die Arylsilylgruppe, die Alkylsilylgruppe, die Alkylborgruppe, die Arylborgruppe, die Phosphingruppe und die Phosphinoxidgruppe von $R_4$ bis $R_{23}$ jeweils unabhängig substituiert oder unsubstituiert sind mit einem oder mehreren Substituenten von: Wasserstoff, Deuterium, einer Halogengruppe, einer Cyanogruppe, einer Nitrogruppe, einer $C_1$- bis $C_{40}$-Alkylgruppe, einer $C_2$- bis $C_{40}$-Alkenylgruppe, einer $C_2$- bis $C_{40}$-Alkinylgruppe, einer $C_3$- bis $C_{40}$-Cycloalkylgruppe, einer Heterocycloalkylgruppe mit 3 bis 40 Kernatomen, einer $C_6$- bis $C_{60}$-Arylgruppe, einer Heteroarylgruppe mit 5 bis 60 Kernatomen, einer $C_1$- bis $C_{40}$-Alkyloxygruppe, einer $C_6$- bis $C_{60}$-Aryloxygruppe, einer $C_1$- bis $C_{40}$-Alkylsilylgruppe, einer $C_6$- bis $C_{60}$-Arylsilylgruppe, einer $C_1$- bis $C_{40}$-Alkylborgruppe, einer $C_6$- bis $C_{60}$-Arylborgruppe, einer $C_6$- bis $C_{60}$-Arylphosphingruppe, einer $C_6$- bis $C_{60}$-Arylphosphinoxidgruppe und einer $C_6$- bis $C_{60}$-Arylamingruppe, und wenn mehrere der Substituenten vorliegen, die Substituenten gleich oder verschieden voneinander sind.

**8.** Organische elektrolumineszente Vorrichtung nach Anspruch 1, wobei die Verbindung, die den mindestens einen Anteil umfasst, eine Verbindung ist, die durch eine beliebige der folgenden chemischen Formeln 2, 3, 6, 8 bis 11, 13

und 14 dargestellt ist:

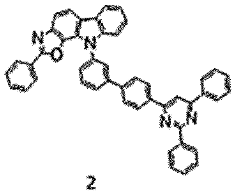

2

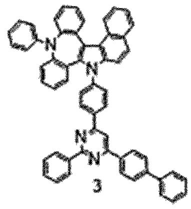

3

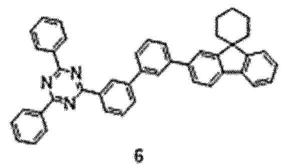

6

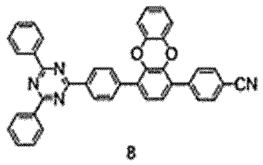

8

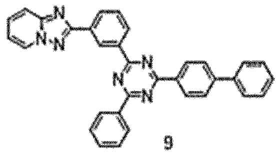

9

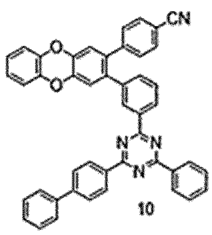

10

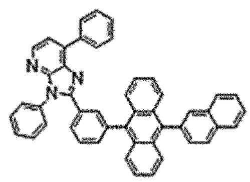

11

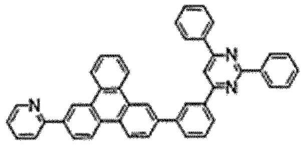

13

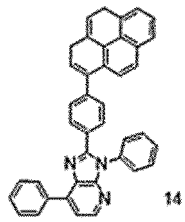

14

**9.** Organische elektrolumineszente Vorrichtung nach Anspruch 1, wobei ein Inhalt von Wirten, die mit dem Material der Elektronentransporthilfsschicht identisch sind, von der Vielzahl von Wirten in einem Bereich von 30 bis 90 Gewichtsprozent (Gew.-%), bezogen auf die Gesamtmenge von ganzen Wirten, liegt.

**10.** Organische elektrolumineszente Vorrichtung nach Anspruch 1, wobei die Vielzahl von Wirten umfasst:

einen ersten Wirt, der mit dem Material der Elektronentransporthilfsschicht identisch ist; und
einen zweiten Wirt, der sich von dem ersten Wirt unterscheidet und den folgenden Vergleichsausdrücken 1 und 2 genügt:

[Vergleichsausdruck 1]

$$|LUMO_{Wirt-1}| > |LUMO_{Wirt-2}|,$$

[Vergleichsausdruck 2]

$$|HOMO_{Wirt-1}| > |HOMO_{Wirt-2}|,$$

wobei in den Vergleichsausdrücken 1 und 2
$LUMO_{Wirt-1}$ ein LUMO-Energieniveau des ersten Wirts ist,

$LUMO_{Wirt-2}$ ein LUMO-Energieniveau des zweiten Wirts ist,
$HOMO_{Wirt-1}$ ein HOMO-Energieniveau des ersten Wirts ist und
$HOMO_{Wirt-2}$ ein HOMO-Energieniveau des zweiten Wirts ist, wobei die HOMO- und die LUMO-Niveaus durch zyklische Voltammetrie und UV-Spektrometrie gemessen wurden.

**11.** Organische elektrolumineszente Vorrichtung nach Anspruch 10, wobei ein Unterschied zwischen einem Absolutwert des LUMO-Energieniveaus des zweiten Wirts und einem Absolutwert des LUMO-Energieniveaus des ersten Wirts in einem Bereich von mehr als 0 eV bis 1,0 eV oder weniger liegt und
ein Unterschied zwischen einem Absolutwert des HOMO-Energieniveaus des zweiten Wirts und einem Absolutwert des HOMO-Energieniveaus des ersten Wirts in einem Bereich von mehr als 0 eV bis 1,0 eV oder weniger liegt.

**12.** Organische elektrolumineszente Vorrichtung nach Anspruch 10, wobei ein Verwendungsverhältnis des ersten Wirts und des zweiten Wirts in einem Bereich von 30:70 bis 90:10, bezogen auf das Gewicht, liegt.

## Revendications

**1.** Dispositif électroluminescent organique comprenant :

une anode (100) ;
une cathode (200) disposée à l'opposé de l'anode (100) ; et
une couche organique (300) disposée entre l'anode (100) et la cathode (200) et comprenant une région de transport de trous (310), une couche photoémettrice (320) et une région de transport d'électrons (330) disposées séquentiellement sur l'anode,
dans lequel la région de transport d'électrons (330) comprend une couche auxiliaire de transport d'électrons (331), une couche de transport d'électrons (332) et une couche d'injection d'électrons (333) disposées séquentiellement sur la couche photoémettrice (320),
la couche photoémettrice (320) comprend une pluralité d'hôtes et de dopants,
**caractérisé en ce qu'**une de la pluralité d'hôtes comprend un matériau identique à un matériau de la couche auxiliaire de transport d'électrons,
dans lequel un matériau de la couche auxiliaire de transport d'électrons comprend un composé représenté par l'une quelconque des formules chimiques suivantes A-1 à A-16 :

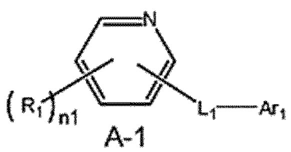
A-1

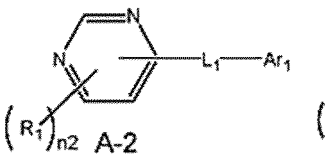
A-2

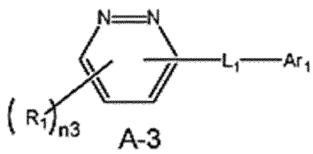
A-3

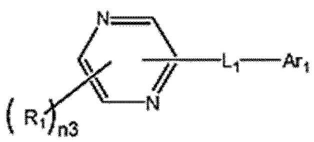
A-4

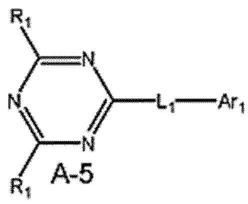
A-5

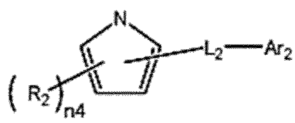
A-6

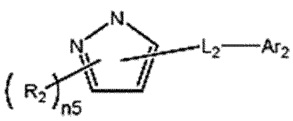
A-7

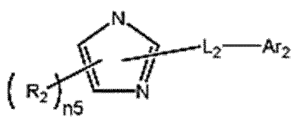
A-8

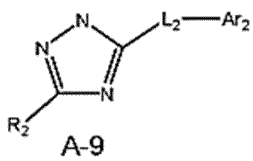
A-9

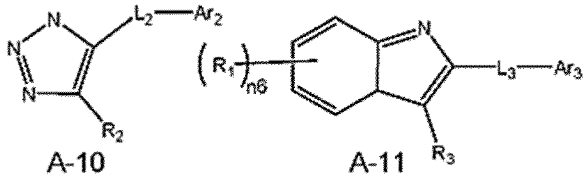

A-10 A-11

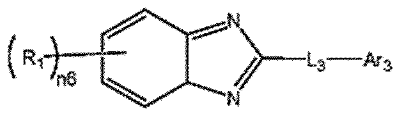

A-12

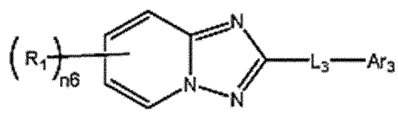

A-13

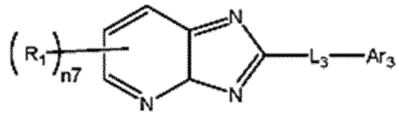

A-14

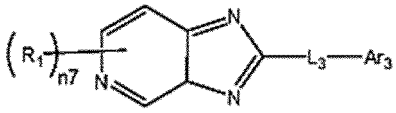

A-15

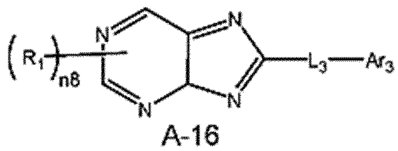

A-16

dans lequel dans les formules chimiques A-1 à A-16,
n1 et n6 sont chacun un nombre entier compris entre 0 et 4,
n2, n3, n4 et n7 sont chacun un nombre entier compris entre 0 et 3, et
n5 et n8 sont chacun un nombre entier compris entre 0 et 2,
$R_1$ et $R_2$ sont identiques ou différents l'un de l'autre, chacun étant indépendamment choisi parmi : l'hydrogène, le deutérium, un groupe halogène, un groupe cyano, un groupe nitro, un groupe amino, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, ou formant un cycle fusionné avec un groupe adjacent, et
le groupe alkyle, le groupe alcényle, le groupe alcynyle, le groupe aryle, le groupe hétéroaryle, le groupe aryloxy, le groupe alkyloxy, le groupe cycloalkyle, le groupe hétérocycloalkyle, le groupe arylsilyle, le groupe alkylsilyle, le groupe alkylbore, le groupe arylbore, le groupe phosphine et le groupe oxyde de phosphine de $R_1$ et $R_2$ sont chacun indépendamment substitués ou non substitués avec un ou plusieurs substituants de : l'hydrogène, le deutérium, un groupe halogène, un groupe cyano, un groupe nitro, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, et lorsque les substituants sont multiples, les substituants sont identiques ou différents les uns des autres,
$L_1$ à $L_3$ sont identiques ou différents les uns des autres, chacun étant indépendamment une simple liaison, ou étant choisi parmi : un groupe arylène en $C_6$ à $C_{18}$ et un groupe hétéroarylène ayant 5 à 18 atomes nucléaires,
dans les formules chimiques A-1, A-6 à A-12, A-14 à A-16, $Ar_1$ à $Ar_3$ sont identiques ou différents les uns des autres, chacun étant indépendamment un substituant choisi parmi les substituants représentés par les formules chimiques S1 à S9 suivantes,
dans les formules chimiques A-2 à A-4, $Ar_1$ est un substituant choisi parmi les substituants représentés par les formules chimiques S1, S2 et S4 à S9 suivantes,
dans la formule chimique A-5, $Ar_1$ est un substituant choisi parmi les substituants représentés par les formules chimiques S2 et S4 à S9 suivantes,
dans la formule chimique A-13, $Ar_3$ est un substituant choisi parmi les substituants représentés par les formules chimiques S1 à S3 et S5 à S9 suivantes,
dans les formules chimiques A-2 à A-4, lorsque $Ar_1$ est un substituant représenté par la formule chimique S3, $L_1$ est choisi parmi un groupe arylène en $C_6$ à $C_{18}$ et un groupe hétéroarylène ayant 5 à 18 atomes nucléaires :

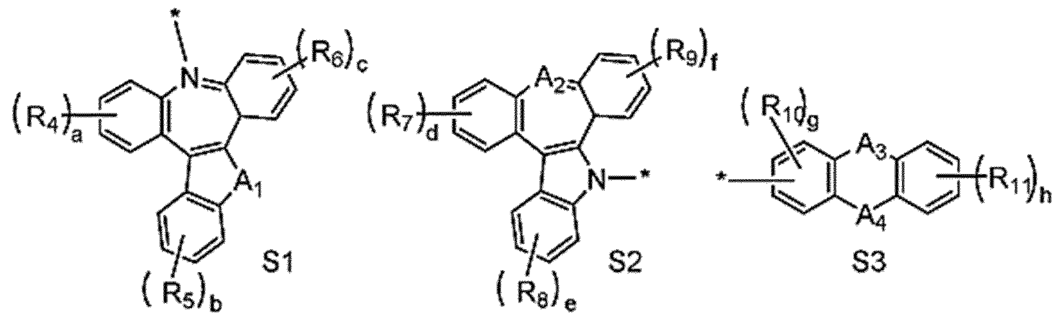

S1 S2 S3

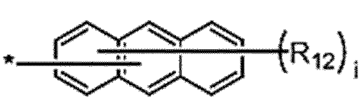

S4

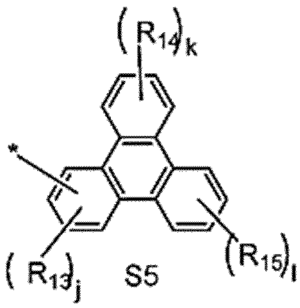

S5

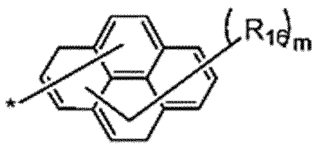

S6

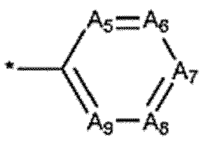

S7

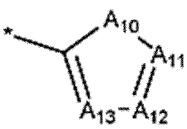

S8

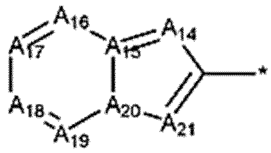

S9

dans les formules chimiques S1 à S9,

$A_1$ et $A_2$ sont N ou $CR_{17}$,

$A_3$ et $A_4$ sont identiques ou différents l'un de l'autre, chacun étant indépendamment une simple liaison, ou étant choisi parmi : $NR_{18}$, O, S et $CR_{19}R_{20}$, dans lequel un cas où les deux de $A_3$ et $A_4$ sont de simples liaisons est exclu,

$A_5$ à $A_9$ sont N ou $CR_{21}$, dans lequel au moins l'un de $A_5$ à $A_9$ est N, et lorsque $CR_{21}$ est multiple, la pluralité de $R_{21}$ sont identiques ou différents les uns des autres,

$A_{10}$ à $A_{13}$ sont N ou $CR_{22}$, dans lequel au moins l'un de $A_{10}$ à $A_{13}$ est N, et lorsque $CR_{22}$ est multiple, la pluralité de $R_{22}$ sont identiques ou différents les uns des autres,

$A_{14}$ à $A_{21}$ sont N ou $CR_{23}$, dans lequel au moins l'un de $A_{14}$ à $A_{21}$ est N, et lorsque $CR_{23}$ est multiple, la pluralité de $R_{23}$ sont identiques ou différents les uns des autres,

a, b, c, d, e, f, h, k et l sont chacun un nombre entier compris entre 0 et 4 ;

g et j sont chacun un nombre entier compris entre 0 et 3,

i et m sont chacun un nombre entier compris entre 0 et 9,

$R_4$ à $R_{23}$ sont identiques ou différents les uns des autres, chacun étant indépendamment choisi parmi : l'hydrogène, le deutérium, un groupe halogène, un groupe cyano, un groupe nitro, un groupe amino, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, ou formant un cycle fusionné avec un groupe adjacent, et

le groupe alkyle, le groupe alcényle, le groupe alcynyle, le groupe aryle, le groupe hétéroaryle, le groupe aryloxy, le groupe alkyloxy, le groupe cycloalkyle, le groupe hétérocycloalkyle, le groupe arylsilyle, le groupe alkylsilyle, le groupe alkylbore, le groupe arylbore, le groupe phosphine et le groupe oxyde de phosphine de $R_4$ à $R_{23}$ sont chacun indépendamment substitués ou non substitués avec un ou plusieurs substituants de : l'hydrogène, le deutérium, un groupe halogène, un groupe cyano, un groupe nitro, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant

5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, et lorsque les substituants sont multiples, les substituants sont identiques ou différents les uns des autres.

**2.** Dispositif électroluminescent organique selon la revendication 1, dans lequel la couche auxiliaire de transport d'électrons (331) satisfait à l'expression relationnelle 3 suivante :

[Expression relationnelle 3]

$$|HOMO_{aETL}| > |HOMO_{EL}|$$

dans laquelle

$HOMO_{aETL}$ est un niveau d'énergie HOMO de la couche auxiliaire de transport d'électrons (331), et
$HOMO_{EL}$ est un niveau d'énergie HOMO de la couche photoémettrice (320) dans laquelle le niveau HOMO a été mesuré par voltamétrie cyclique.

**3.** Dispositif électroluminescent organique selon la revendication 2, dans lequel une différence entre une valeur absolue du niveau d'énergie HOMO de la couche auxiliaire de transport d'électrons (331) et une valeur absolue du niveau d'énergie HOMO de la couche photoémettrice (320) est comprise entre plus de 0 eV et 1,0 eV ou moins.

**4.** Dispositif électroluminescent organique selon la revendication 1, dans lequel la couche auxiliaire de transport d'électrons (331) satisfait à l'expression relationnelle 4 suivante :

[Expression relationnelle 4]

$$|LUMO_{ETL}| > |LUMO_{aETL}| > |LUMO_{EL}|$$

dans laquelle

$LUMO_{ETL}$ est un niveau d'énergie LUMO de la couche de transport d'électrons (332),
$LUMO_{aETL}$ est un niveau d'énergie LUMO de la couche auxiliaire de transport d'électrons (331), et
$LUMO_{EL}$ est un niveau d'énergie LUMO de la couche photoémettrice (320) dans laquelle le niveau LUMO a été mesuré par voltamétrie cyclique et spectrométrie UV.

**5.** Dispositif électroluminescent organique selon la revendication 4, dans lequel une différence entre une valeur absolue du niveau d'énergie LUMO de la couche auxiliaire de transport d'électrons (331) et une valeur absolue du niveau d'énergie LUMO de la couche de transport d'électrons (332) est comprise entre plus de 0 eV et 1,0 eV ou moins.

**6.** Dispositif électroluminescent organique selon la revendication 4, dans lequel une différence entre une valeur absolue du niveau d'énergie LUMO de la couche auxiliaire de transport d'électrons (331) et une valeur absolue du niveau d'énergie LUMO de la couche photoémettrice (320) est comprise entre plus de 0 eV et 1,0 eV ou moins.

**7.** Dispositif électroluminescent organique selon la revendication 1, dans lequel le composé représenté par l'une quelconque des formules chimiques A-1 à A-16 est choisi parmi les formules chimiques B-1 à B-6, B-8 et B-9 suivantes :

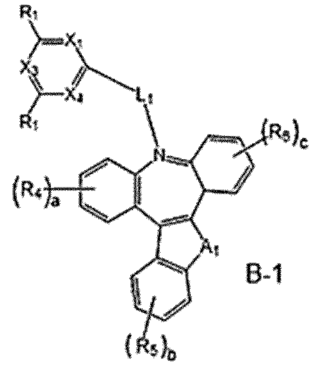
B-1

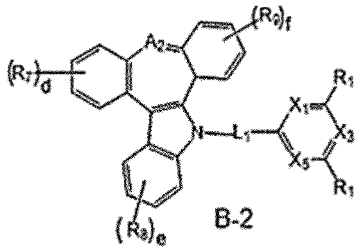
B-2

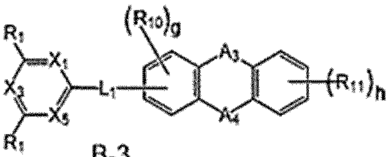
B-3

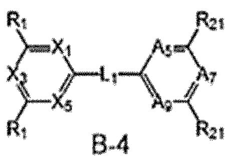
B-4

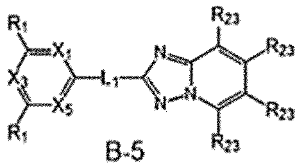
B-5

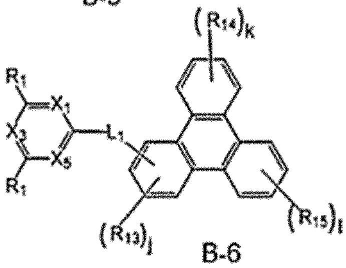
B-6

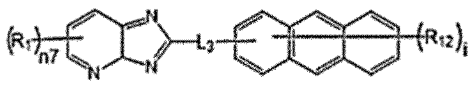
B-8

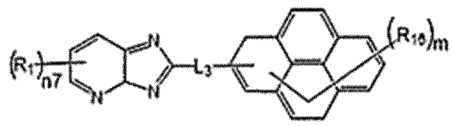
B-9

dans la formule chimique B-1, $X_1$, $X_3$ et $X_5$ sont identiques ou différents les uns des autres, chacun étant indépendamment N ou $C(R_1)$, où un ou deux de $X_1$, $X_3$ et $X_5$ est N,

dans les formules chimiques B-2, B-4 à B-6, $X_1$, $X_3$ et $X_5$ sont identiques ou différents les uns des autres, chacun étant indépendamment N ou $C(R_1)$, où au moins l'un de $X_1$, $X_3$ et $X_5$ est N,

dans la formule chimique B-3, $X_1$, $X_3$ et $X_5$ sont identiques ou différents les uns des autres, chacun étant indépendamment N ou $C(R_1)$, où un de $X_1$, $X_3$ et $X_5$ est N,

dans lequel dans les formules chimiques B-1 à B-6, B-8 et B-9,

la pluralité de $R_1$ sont identiques ou différents les uns des autres, chacun étant indépendamment choisi parmi : l'hydrogène, le deutérium, un groupe halogène, un groupe cyano, un groupe nitro, un groupe amino, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, ou formant un cycle fusionné avec un groupe adjacent,

le groupe alkyle, le groupe alcényle, le groupe alcynyle, le groupe aryle, le groupe hétéroaryle, le groupe aryloxy, le groupe alkyloxy, le groupe cycloalkyle, le groupe hétérocycloalkyle, le groupe arylsilyle, le groupe alkylsilyle, le groupe alkylbore, le groupe arylbore, le groupe phosphine et le groupe oxyde de phosphine de $R_1$ sont chacun indépendamment substitués ou non substitués avec un ou plusieurs substituants de : l'hydrogène, le deutérium, un groupe halogène, un groupe cyano, un groupe nitro, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un

groupe oxyde d'arylphosphine en $C_6$ à $C_{60}$ et un groupe arylamine en $C_6$ à $C_{60}$, et lorsque les substituants sont multiples, les substituants sont identiques ou différents les uns des autres,
dans lequel dans les formules chimiques B-1, B-2, B-4 à B-6, B-8 et B-9, $L_1$ et $L_3$ sont identiques ou différents l'un de l'autre, chacun étant indépendamment une simple liaison, ou étant choisi parmi : un groupe arylène en $C_6$ à $C_{18}$ et un groupe hétéroarylène ayant 5 à 18 atomes nucléaires,
dans lequel dans la formule chimique B-3, $L_3$ est choisi parmi : un groupe arylène en $C_6$ à $C_{18}$ et un groupe hétéroarylène ayant 5 à 18 atomes nucléaires,
$A_1$ et $A_2$ sont N ou $CR_{17}$,
$A_3$ et $A_4$ sont identiques ou différents l'un de l'autre, chacun étant indépendamment une simple liaison, ou étant choisi parmi : $NR_{18}$, O, S et $CR_{19}R_{20}$, dans lequel un cas où les deux de $A_3$ et $A_4$ sont de simples liaisons est exclu,
$A_5$, $A_7$ et $A_9$ sont N ou $CR_{21}$, dans lequel au moins l'un de $A_5$, $A_7$ et $A_9$ est N, et lorsque $CR_{21}$ est multiple, la pluralité de $R_{21}$ sont identiques ou différents les uns des autres,
a, b, c, d, e, f, h, k et l sont chacun un nombre entier compris entre 0 et 4 ;
g et j sont chacun un nombre entier compris entre 0 et 3,
i et m sont chacun un nombre entier compris entre 0 et 9,
$n_6$ est un nombre entier compris entre 0 et 4,
$n_7$ est un nombre entier compris entre 0 et 3,
$R_4$ à $R_{23}$ sont identiques ou différents les uns des autres, chacun étant indépendamment choisi parmi : l'hydrogène, le deutérium, un groupe halogène, un groupe cyano, un groupe nitro, un groupe amino, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, ou formant un cycle fusionné avec un groupe adjacent, et
le groupe alkyle, le groupe alcényle, le groupe alcynyle, le groupe aryle, le groupe hétéroaryle, le groupe aryloxy, le groupe alkyloxy, le groupe cycloalkyle, le groupe hétérocycloalkyle, le groupe arylsilyle, le groupe alkylsilyle, le groupe alkylbore, le groupe arylbore, le groupe phosphine et le groupe oxyde de phosphine de $R_4$ à $R_{23}$ sont chacun indépendamment substitués ou non substitués avec un ou plusieurs substituants de : l'hydrogène, le deutérium, un groupe halogène, un groupe cyano, un groupe nitro, un groupe alkyle en $C_1$ à $C_{40}$, un groupe alcényle en $C_2$ à $C_{40}$, un groupe alcynyle en $C_2$ à $C_{40}$, un groupe cycloalkyle en $C_3$ à $C_{40}$, un groupe hétérocycloalkyle ayant 3 à 40 atomes nucléaires, un groupe aryle en $C_6$ à $C_{60}$, un groupe hétéroaryle ayant 5 à 60 atomes nucléaires, un groupe alkyloxy en $C_1$ à $C_{40}$, un groupe aryloxy en $C_6$ à $C_{60}$, un groupe alkylsilyle en $C_1$ à $C_{40}$, un groupe arylsilyle en $C_6$ à $C_{60}$, un groupe alkylbore en $C_1$ à $C_{40}$, un groupe arylbore en $C_6$ à $C_{60}$, un groupe arylphosphine en $C_6$ à $C_{60}$, un groupe oxyde d'arylphosphine en $C_6$ à $C_{60}$ et un groupe arylamine en $C_6$ à $C_{60}$, et lorsque les substituants sont multiples, les substituants sont identiques ou différents les uns des autres.

**8.** Dispositif électroluminescent organique selon la revendication 1, dans lequel le composé comprenant l'au moins un fragment est un composé représenté par l'une quelconque des formules chimiques 2, 3, 6, 8 à 11, 13 et 14 suivantes :

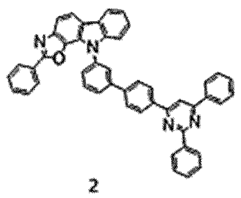

2

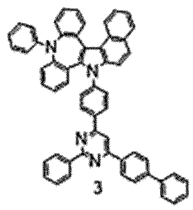

3

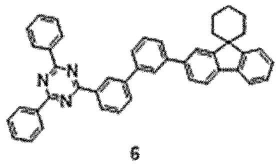

6

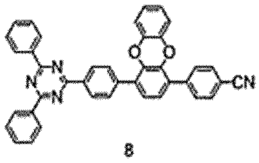

8

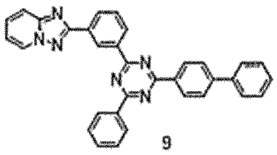

9

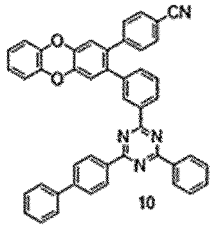

10

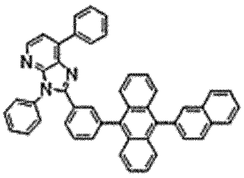

11

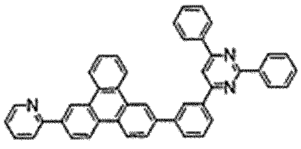

13

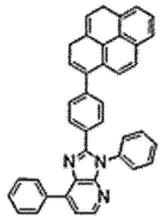

14

**9.** Dispositif électroluminescent organique selon la revendication 1, dans lequel une teneur en hôtes identiques au matériau de la couche auxiliaire de transport d'électrons parmi la pluralité d'hôtes est comprise entre 30 et 90 pour cent en masse (% m) par rapport à la quantité totale d'hôtes entiers.

**10.** Dispositif électroluminescent organique selon la revendication 1, dans lequel la pluralité d'hôtes comprend :

un premier hôte identique au matériau de la couche auxiliaire de transport d'électrons ; et
un deuxième hôte différent du premier hôte et satisfaisant aux expressions relationnelles 1 et 2 :

[Expression relationnelle 1]

$$|LUMO_{host-1}| > |LUMO_{host-2}|,$$

[Expression relationnelle 2]

$$|HOMO_{host-1}| > |HOMO_{host-2}|,$$

dans laquelle dans les expressions relationnelles 1 et 2,
$LUMO_{host-1}$ est un niveau d'énergie LUMO du premier hôte,
$LUMO_{host-2}$ est un niveau d'énergie LUMO du deuxième hôte,
$HOMO_{host-1}$ est un niveau d'énergie HOMO du premier hôte, et
$HOMO_{host-2}$ est un niveau d'énergie HOMO du deuxième hôte, où les niveaux HOMO et LUMO ont été mesurés par voltamétrie cyclique et spectrométrie UV.

**11.** Dispositif électroluminescent organique selon la revendication 10, dans lequel une différence entre une valeur absolue du niveau d'énergie LUMO du deuxième hôte et une valeur absolue du niveau d'énergie LUMO du premier hôte est comprise entre plus de 0 eV et 1,0 eV ou moins, et
une différence entre une valeur absolue du niveau d'énergie HOMO du deuxième hôte et une valeur absolue du niveau d'énergie HOMO du premier hôte est comprise entre plus de 0 eV et 1,0 eV ou moins.

**12.** Dispositif électroluminescent organique selon la revendication 10, dans lequel un ratio d'utilisation du premier hôte et du deuxième hôte est compris entre 30:70 et 90:10 en masse.

FIG. 1

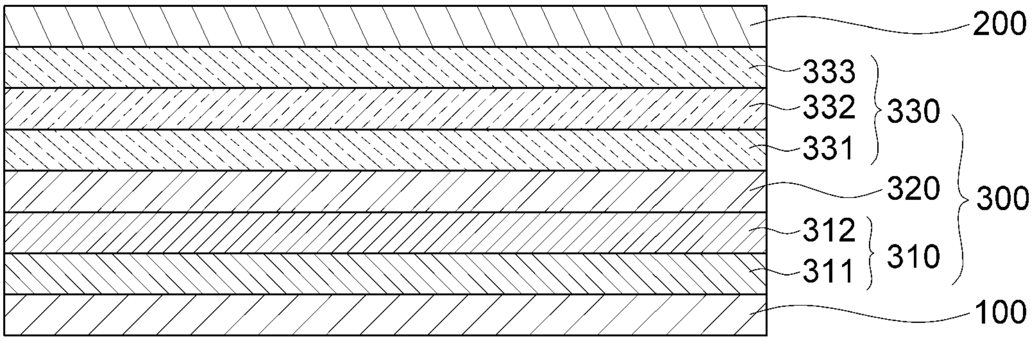
200
333
332
331
330
320
300
312
311
310
100

FIG. 2

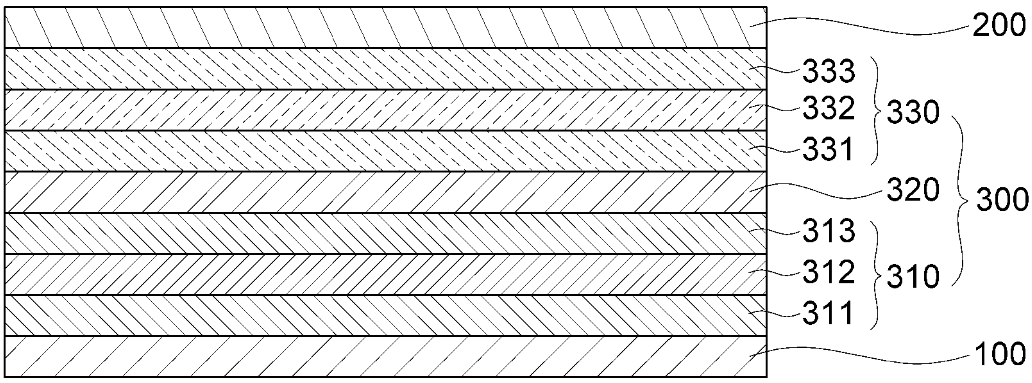
200
333
332
331
330
320
300
313
312
311
310
100

FIG. 3

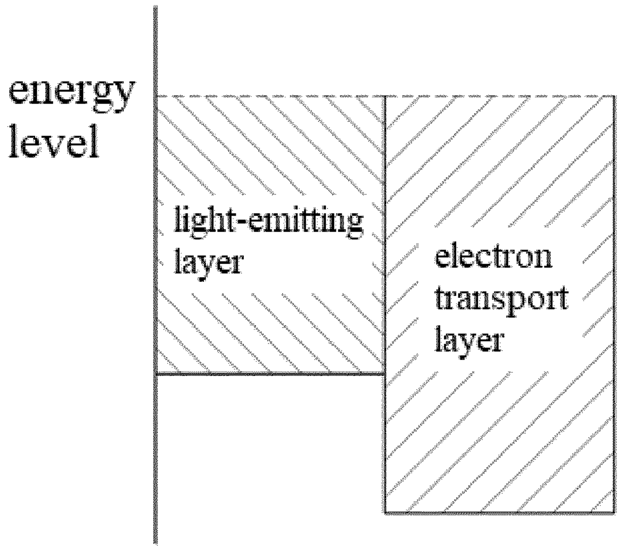
energy
level
light-emitting
layer
electron
transport
layer

FIG. 4

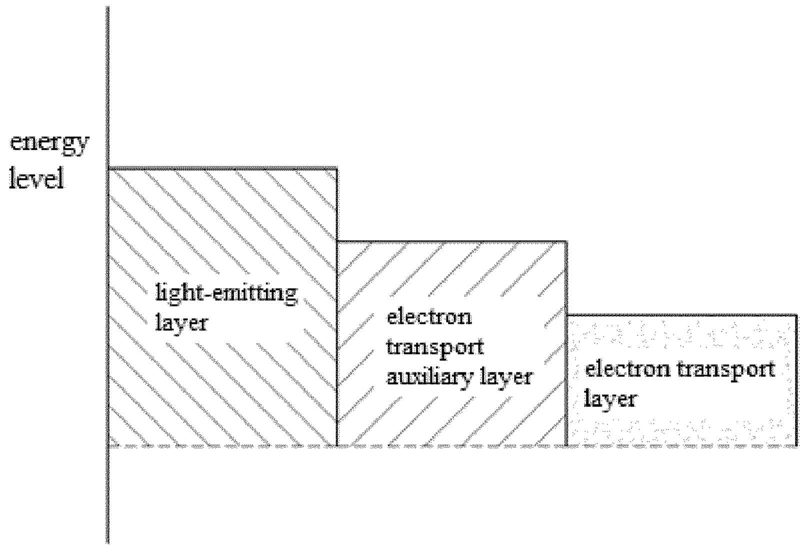
energy
level
light-emitting
layer
electron
transport
auxiliary layer
electron transport
layer

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3480278 A1
- KR 101884130 B1
- US 2016149150 A1
- KR 20180072245 A
- KR 20190088651 A